# EUROPEAN PATENT APPLICATION

(11) **EP 4 404 266 A1**
(43) Date of publication of application: **24.07.2024**
(21) Application number: 24152369.5
(22) Date of filing: 17.01.2024
(51) Int. Cl.: H01L 27/146

(54) **IMAGE SENSOR AND ELECTRONIC APPARATUS INCLUDING THE IMAGE SENSOR**

(30) Priority: 19.01.2023 KR 20230008102
(71) Applicant: Samsung Electronics Co., Ltd., Suwon-si, Gyeonggi-do 16677 (KR)
(72) Inventor: ROH, Sookyoung, 16678 Suwon-si (KR); CHO, Choonlae, 16678 Suwon-si (KR); YUN, Seokho, 16678 Suwon-si (KR)
(74) Representative: Elkington and Fife LLP

(57) **Abstract**

An image sensor includes a sensor substrate including first to third pixel groups, and a color separation lens array configured to separate incident light according to wavelengths, multi-condense blue light onto a plurality of continuously arranged first pixels of the first pixel group, multi-condense green light onto the plurality of continuously arranged second pixels of the second pixel group, and multi-condense red light onto the plurality of continuously arranged third pixels of the third pixel group. The color separation lens array includes first to third pixel correspondence regions respectively facing the first to third pixel groups and including a plurality of nanoposts. A blue light phase profile viewed in a cross-section immediately after passing through the first pixel correspondence region includes a plurality of maximum points having positions that are not aligned with a center of the plurality of first pixels.

## Description

### FIELD OF THE INVENTION

The present disclosure relates to image sensors, and more particularly, to an image sensor including a color separation lens array and an electronic apparatus including the same.

### BACKGROUND OF THE INVENTION

Image sensors may generally sense the color of incident light by using a color filter. However, a color filter may have low light utilization efficiency because the color filter absorbs light of colors other than light of the intended color. For example, in the case of a red-green-blue (RGB) color filter, only one third of the incident light is transmitted therethrough and the remaining part of the incident light, that is, two thirds of the incident light, is absorbed. Thus, the light utilization efficiency of an RGB color filter may only be about 33%. Typically, a majority of the light loss in an image sensor may occur in a color filter. Accordingly, a method of separating colors by using each pixel in an image sensor without using a color filter has been attempted.

### SUMMARY OF THE INVENTION

One or more example embodiments of the present disclosure provide an image sensor including a color separation lens array capable of separating incident light according to wavelengths and condensing separated light.

One or more example embodiments of the present disclosure provide an image sensor including a multi-channel pixel with improved light efficiency when compared to related image sensors.

According to an aspect of the disclosure, an image sensor includes: a sensor substrate including: a first pixel group including a plurality of first pixels that are continuously arranged; a second pixel group including a plurality of second pixels that are continuously arranged; and a third pixel group including a plurality of third pixels that are continuously arranged; and a color separation lens array configured to: separate incident light into green light, blue light, and red light, according to wavelengths; multi-condense the blue light onto the plurality of first pixels, multi-condense the green light onto the plurality of second pixels, and multi-condense the red light onto the plurality of third pixels, wherein the color separation lens array may include: a first pixel correspondence region facing the first pixel group and including a plurality of first nanoposts; a second pixel correspondence region facing the second pixel group and including a plurality of second nanoposts; and a third pixel correspondence region facing the third pixel group and including a plurality of third nanoposts, wherein a blue light phase profile viewed in a first cross-section immediately after passing through the first pixel correspondence region may include a plurality of first maximum points, wherein a number of points in the plurality of first maximum points is the same as a first number of pixels in the plurality of first pixels, and wherein first positions of the plurality of first maximum points are not aligned with and deviate from a first center of the plurality of first pixels.

The first positions of the plurality of first maximum points may be spaced apart from positions facing the first center of the plurality of first pixels in a direction toward a center of the first pixel correspondence region.

A red light phase profile viewed from a third cross-section immediately after passing through the third pixel correspondence region may include a plurality of third maximum points, a number of the plurality of third maximum points may be the same as a number of the plurality of third pixels, and third positions of the plurality of third maximum points may not be aligned with and deviate from a third center of the plurality of third pixels.

The third positions of the plurality of third maximum points of the red light phase profile may be spaced apart from positions facing the third center of the plurality of third pixels in a direction toward a center of the third pixel correspondence region.

A green light phase profile viewed from a second cross-section immediately after passing through the second pixel correspondence region may include a plurality of second maximum points, a number of the plurality of second maximum points is the same as a number of the plurality of second pixels, and second positions of the plurality of second maximum points may not be aligned with and deviate from a second center of the plurality of second pixels.

The second positions of the plurality of second maximum points of the green light phase profile may be spaced apart from positions facing the second center of the plurality of second pixels in a direction toward a center of the second pixel correspondence region.

The sensor substrate may further include a fourth pixel group including a plurality of fourth pixels that are continuously arranged, and the first pixel group, the second pixel group, the third pixel group, and the fourth pixel group are arranged in a 2×2 shape in a first direction and a second direction.

Each of the plurality of first pixels, each of the plurality of second pixels, each of the plurality of third pixels, and each of the plurality of fourth pixels may include four photosensitive cells arranged in the 2×2 shape in the first and second directions, and each of the four photosensitive cells may be configured to independently sense the incident light.

At least two areas of cross-sections of the four photosensitive cells may be different from each other.

Each of the plurality of first pixels, each of the plurality of second pixels, each of the plurality of third pixels, and each of the plurality of fourth pixels may include two photosensitive cells arranged in the 2×2 shape in the first and second directions, and the two photosensitive cells may be configured to independently sense the incident light.

According to an aspect of the disclosure, an image sensor includes: a sensor substrate including: a first pixel group including a plurality of first pixels that are continuously arranged; a second pixel group including a plurality of second pixels that are continuously arranged; a third pixel group including a plurality of third pixels that are continuously arranged; and a fourth pixel group including a plurality of fourth pixels that are continuously arranged; and a color separation lens array configured to: separate incident light into green light, blue light, and red light, according to wavelengths, multi-condense the green light onto the plurality of first pixels and the plurality of fourth pixels; multi-condense the blue light onto the plurality of second pixels, and multi-condense the red light onto the plurality of third pixels, wherein the color separation lens array may include: a first pixel correspondence region facing the first pixel group and including a plurality of first nanoposts; a second pixel correspondence region facing the second pixel group and including a plurality of second nanoposts; a third pixel correspondence region facing the third pixel group and including a plurality of third nanoposts; and a fourth pixel correspondence region facing the fourth pixel group and including a plurality of fourth nanoposts, wherein the plurality of second nanoposts are arranged to have symmetry with respect to a second diagonal line of a second cross-section of the second pixel correspondence region, and wherein the plurality of third nanoposts are arranged to have symmetry with respect to a third diagonal line of a third cross-section of the third pixel correspondence region.

The second pixel correspondence region may include a plurality of sub regions facing the plurality of second pixels, four second central nanoposts may be disposed at a center of each of the plurality of sub regions, and cross-sectional sizes of the four second central nanoposts may be larger than cross-sectional sizes of the plurality of second nanoposts disposed at a periphery of each of the plurality of sub regions.

A center of an arrangement of the four second central nanoposts may be spaced apart from a center of each of the plurality of sub regions toward a center of the second pixel correspondence region.

The third pixel correspondence region may include a plurality of sub regions facing the plurality of third pixels, four third central nanoposts may be disposed at a center of each of the plurality of sub regions, and cross-sectional sizes of the four third central nanoposts may be larger than cross-sectional sizes of the plurality of third nanoposts disposed at a periphery of each of the plurality of sub regions.

A center of an arrangement of the four third central nanoposts may be spaced apart from a center of each of the plurality of sub regions toward a center of the third pixel correspondence region.

The first pixel group, the second pixel group, the third pixel group, and the fourth pixel group are arranged in a 2×2 shape in a first direction and a second direction, each of the plurality of first pixels, each of the plurality of second pixels, each of the plurality of third pixels, and each of the plurality of fourth pixels may include four photosensitive cells arranged in the 2×2 matrix shape in the first and second directions, and the four photosensitive cells are configured to independently sense the incident light.

Each of the first pixel correspondence region, the second pixel correspondence region, the third pixel correspondence region, and the fourth pixel correspondence region may include a plurality of basic regions partitioned in a same number as a number of cells of the four photosensitive cells facing each other, and four nanoposts having at least two types of cross-sectional sizes may be disposed in each of the plurality of basic regions.

At least two areas of cross-sections of the four photosensitive cells may be different from each other.

According to an aspect of the disclosure, an electronic apparatus includes: a lens assembly including at least one lens and configured to form an optical image of an object; an image sensor configured to convert the optical image formed by the lens assembly into an electrical signal; and a processor configured to process a signal generated by the image sensor, wherein the image sensor includes: a sensor substrate including: a first pixel group including a plurality of first pixels that are continuously arranged; a second pixel group including a plurality of second pixels that are continuously arranged; and a third pixel group including a plurality of third pixels that are continuously arranged; and a color separation lens array configured to: separate incident light into green light, blue light, and red light, according to wavelengths; multi-condense the blue light onto the plurality of first pixels, multi-condense the green light onto the plurality of second pixels, and multi-condense the red light onto the plurality of third pixels, wherein the color separation lens array may include: a first pixel correspondence region facing the first pixel group and including a plurality of first nanoposts; a second pixel correspondence region facing the second pixel group and including a plurality of second nanoposts; and a third pixel correspondence region facing the third pixel group and including a plurality of third nanoposts, wherein a blue light phase profile viewed in a first cross-section immediately after passing through the first pixel correspondence region may include a plurality of maximum points, wherein a number of points in the plurality of maximum points is the same as a number of pixels in the plurality of first pixels, and wherein first positions of the plurality of maximum points are not aligned with and deviate from a center of the plurality of first pixels.

The first positions of the plurality of maximum points may be spaced apart from positions facing the center of the plurality of first pixels in a direction toward a center of the first pixel correspondence region.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a block diagram of an image sensor, according to an embodiment;
FIG. 2A is a plan view showing a color arrangement of a pixel array in an image sensor, according to an embodiment;
FIGS. 2B and 2C are plan views showing a sensor substrate and a color separation lens array included in the pixel array of the image sensor, according to an embodiment;
FIGS. 3A and 3B are different cross-sectional views of a pixel array of an image sensor according to an embodiment;
FIGS. 4 is a diagram showing a phase profile of blue light immediately after passing through a color separation lens array included in a pixel array of an image sensor, according to an embodiment;
FIG. 5 is a diagram showing a distribution in which the blue light of the phase profile shown in FIG. 4 is condensed onto blue pixels of a sensor substrate, according to an embodiment;
FIG. 6 is a diagram showing a phase profile of green light immediately after passing through a color separation lens array included in a pixel array of an image sensor, according to an embodiment;
FIG. 7 is a diagram showing a distribution in which the green light of the phase profile shown in FIG. 6 is condensed onto green pixels of a sensor substrate, according to an embodiment;
FIG. 8 is a diagram showing a phase profile of red light immediately after passing through a color separation lens array included in a pixel array of an image sensor, according to an embodiment;
FIG. 9 is a diagram showing a distribution in which the red light of the phase profile shown in FIG. 8 is condensed onto red pixels of a sensor substrate, according to an embodiment;
FIG. 10 is a diagram showing a phase profile of blue light immediately after passing through a color separation lens array included in a pixel array of an image sensor, according to an embodiment;
FIG. 11 is a diagram showing a distribution of the blue light of the phase profile shown in FIG. 10 condensed onto blue pixels of a sensor substrate, according to an embodiment;
FIG. 12 is a diagram showing a distribution of green light condensed onto green pixels of a sensor substrate of a pixel array of an image sensor, according to an embodiment;
FIG. 13 is a diagram showing a distribution of red light condensed onto red pixels of a sensor substrate of a pixel array of an image sensor, according to an embodiment;
FIG. 14 is a diagram showing a phase profile of blue light immediately after passing through a color separation lens array included in a pixel array of an image sensor, according to an embodiment;
FIG. 15 is a diagram showing a distribution of the blue light of the phase profile shown in FIG. 14 condensed onto blue pixels of a sensor substrate, according to an embodiment;
FIG. 16 is a diagram showing a distribution of green light condensed onto green pixels of a sensor substrate of a pixel array of an image sensor, according to an embodiment;
FIG. 17 is a diagram showing a distribution of red light condensed onto red pixels of a sensor substrate of a pixel array of an image sensor, according to an embodiment;
FIG. 18A is a plan view showing a color arrangement of a pixel array of an image sensor, according to an embodiment;
FIGS. 18B and 18C are plan views showing a sensor substrate and a color separation lens array included in the pixel array of the image sensor, according to an embodiment;
FIG. 19 is a plan view showing a configuration of a color separation lens array included in a pixel array of an image sensor, according to an embodiment;
FIG. 20 is a graph showing quantum efficiency of an image sensor for each wavelength, according to an embodiment;
FIG. 21 is a diagram showing a distribution of green light condensed onto green pixels of a sensor substrate of a pixel array of an image sensor, according to an embodiment;
FIG. 22 is a graph showing optical signals in a plurality of channels of green pixels in an image sensor, according to an embodiment;
FIG. 23 is a plan view showing a configuration of a color separation lens array included in a pixel array of an image sensor, according to an embodiment;
FIG. 24 is a graph showing optical signals in a plurality of channels of green pixels in an image sensor, according to an embodiment;
FIG. 25 is a plan view showing a sensor substrate of a pixel array of an image sensor, according to an embodiment;
FIG. 26 is a diagram showing a distribution of green light condensed onto green pixels illustrated in FIG. 25, according to an embodiment;
FIG. 27 is a cross-sectional view showing a pixel array of an image sensor, according to an embodiment;
FIG. 28 is a schematic block diagram of an electronic apparatus including an image sensor, according to some embodiments; and
FIG. 29 is a schematic block diagram of a camera module included in the electronic apparatus of FIG. 28, according to an embodiment.

### DETAILED DESCRIPTION

Reference will now be made in detail to embodiments, examples of which are illustrated in the accompanying drawings, wherein like reference numerals refer to like components throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of components, modify the entire list of components and do not modify the individual components of the list.

The embodiments will be described in detail below with reference to accompanying drawings. The embodiments described herein are provided merely as an example, and may be embodied in many different forms. In the drawings, like reference numerals denote like components, and sizes of components in the drawings may be exaggerated for convenience of explanation.

Hereinafter, it will be understood that when a component is referred to as being "above" or "on" another component, the component may be directly on the other component or over the other component in a non-contact manner.

It will be understood that although the terms "first," "second," and the like, may be used herein to describe various components, these terms are only be used to distinguish one component from another. These terms do not limit that materials and/or structures of components are different from one another.

An expression used in the singular may encompass the expression of the plural, unless the expression has a clearly different meaning in the context. It will be further understood that when a portion is referred to as "comprising" another component, the portion may not exclude another component but may further comprise another component unless the context states otherwise.

In addition, as used herein, the terms "... unit" and "... module" used herein specify a unit for processing at least one function and/or operation, which may be implemented with hardware, software, and/or a combination of hardware and software.

The use of the terms "a", "an", "the", and similar referents may be construed to cover both the singular and the plural.

The steps and/or operations of methods described herein may be performed in any suitable order unless otherwise indicated herein or otherwise clearly contradicted by context. In addition, the use of exemplary terms (e.g., etc., and the like) provided herein, are intended merely to better illuminate the technical ideas and does not pose a limitation on the scope of rights unless otherwise claimed.

As used herein, each of the terms "GaAs", "GaN", "GaP", "SiC", "SiN", "SiO₂", "TiO₂", and the like may refer to a material made of elements included in each of the terms and is not a chemical formula representing a stoichiometric relationship.

Hereinafter, various embodiments of the present disclosure are described with reference to the accompanying drawings.

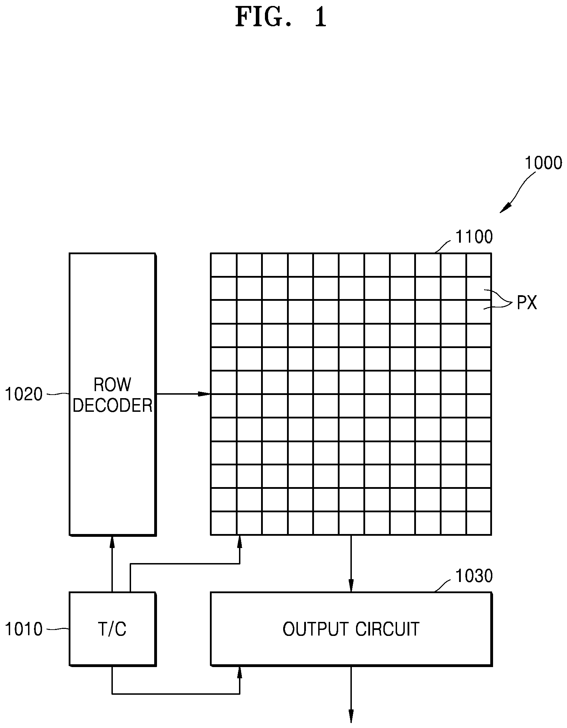

Referring to FIG. 1, an image sensor 1000 may include a pixel array 1100, a timing controller 1010, a row decoder 1020, and an output circuit 1030. The image sensor 1000 may include a charge-coupled device (CCD) image sensor and/or a complementary metal oxide semiconductor (CMOS) image sensor.

The pixel array 1100 includes pixels that are two-dimensionally (2D) arranged in a plurality of rows and columns. The row decoder 1020 selects one of the rows in the pixel array 1100 in response to a row address signal output from the timing controller 1010. The output circuit 1030 outputs a photosensitive signal, in a column unit, from a plurality of pixels arranged in the selected row. In some embodiments, the output circuit 1030 may include a column decoder and an analog-to-digital converter (ADC). For example, the output circuit 1030 may include a plurality of ADCs that may be respectively arranged to columns between the column decoder and the pixel array 1100. Alternatively or additionally, one ADC may be arranged at an output end of the column decoder. The timing controller 1010, the row decoder 1020, and the output circuit 1030 may be implemented as one chip or as separate (multiple) chips. A processor for processing an image signal output from the output circuit 1030 may be implemented as one chip along with the timing controller 1010, the row decoder 1020, and the output circuit 1030.

The pixel array 1100 may include a plurality of pixels PX that may sense light of different wavelengths. The pixel arrangement may be implemented in various ways. The pixel array 1100 may include a color separation lens array that separates incident light according to wavelengths so that light of different wavelengths (e.g., colors) may be incident on the plurality of pixels PX.

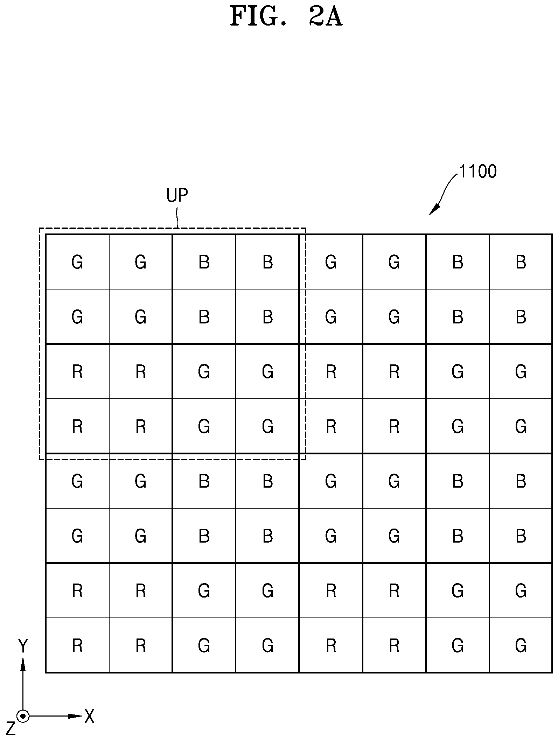

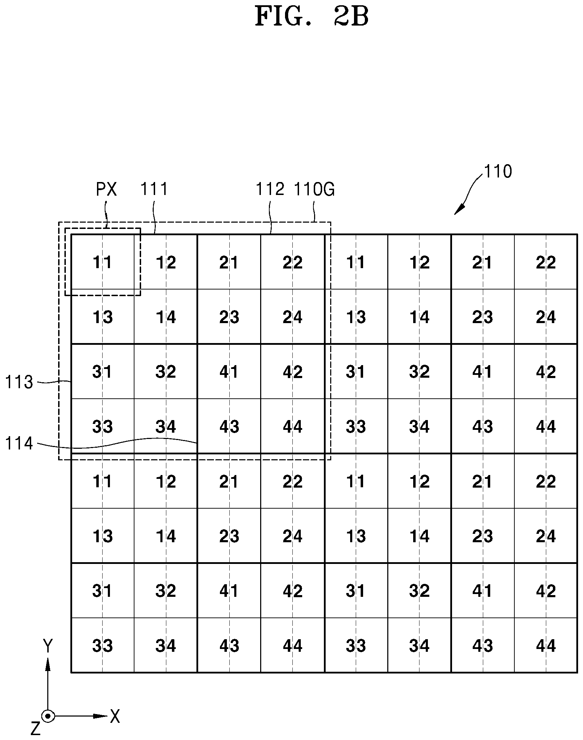

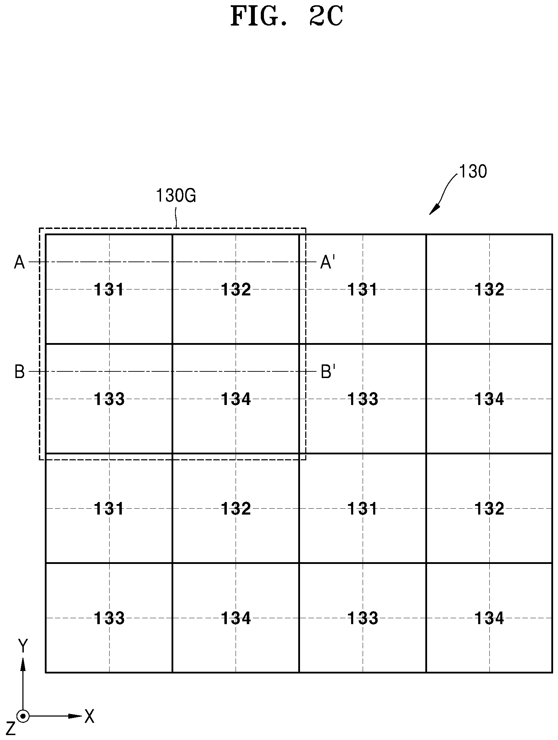

FIG. 2A is a plan view showing a color arrangement of a pixel array 1100 in an image sensor 1000, according to an embodiment. FIGS. 2B and 2C are plan views showing a sensor substrate and a color separation lens array included in the pixel array 1100 of the image sensor 1000, according to an embodiment.

The color arrangement shown in FIG. 2A is similar to a Bayer pattern, but is different from the Bayer pattern in that the same colors are adjacent to each other in a 2×2 arrangement. A 2×2 arrangement of green (G) color, a 2×2 arrangement of blue (B) color, a 2×2 arrangement of red (R) color, and a 2×2 arrangement of green (G) color may form a unit pattern UP. The unit patterns UP may be repeatedly and/or two-dimensionally (2D) arranged in a first direction (X direction) and a second direction (Y direction). Such a color arrangement may be used to improve sensitivity of an ultrasmall image sensor, when compared to a related image sensor.

It may be understood that the color arrangement of FIG. 2A is an example, and embodiments of the present disclosure are not limited thereto. For example, a CYGM method, in which magenta (M), cyan (C), yellow (Y), and green (G) are represented in one unit pattern, and/or an RGBW method in which green, red, blue, and white are represented in one unit pattern may be used without deviating from the scope of the present disclosure. In addition, the unit patterns may be implemented in a 3×2 array. That is, the pixels in the pixel array 1100 may be arranged in various ways according to color characteristics of the image sensor 1000. Hereinafter, a color arrangement based on red (R), green (G), and blue (B) is described, but may be changed and applied to other types of color arrangements.

The pixel array 1100 of the image sensor 1000 may include a sensor substrate 110 having a pixel arrangement corresponding to such a color arrangement and a color separation lens array 130 condensing light of a color corresponding to a specific pixel. FIGS. 2B and 2C are plan views showing the sensor substrate 110 and the color separation lens array 130.

Referring to FIG. 2B, the sensor substrate 110 may include the plurality of pixels PX sensing incident light. That is, the plurality of pixels PX may generate an image signal by converting the incident light into an electrical signal. The sensor substrate 110 may include a plurality of unit pixel groups 110G. The unit pixel groups 110G may have a one-to-one correspondence to the unit patterns UP of FIG. 2A. For example, the unit pixel group 110G may include a first pixel group 111, a second pixel group 112, a third pixel group 113, and a fourth pixel group 114. In such an example, the first pixel group 111 may include four first pixels (e.g., first first pixel 11, second first pixel 12, third first pixel 13, and fourth first pixel 14) in a 2×2 arrangement, the second pixel group 112 may include four second pixels (e.g., first second pixel 21, second second pixel 22, third second pixel 23, and fourth second pixel 24) in a 2×2 arrangement, the third pixel group 113 may include four third pixels (e.g., first third pixel 31, second third pixel 32, third third pixel 33, and fourth third pixel 34) in a 2×2 arrangement, and the fourth pixel group 114 may include four fourth pixels (e.g., first fourth pixel 41, second fourth pixel 42, third fourth pixel 43, and fourth fourth pixel 44) in a 2×2 arrangement.

The pixel arrangement of the sensor substrate 110 is configured to sense the incident light by classifying the incident light into colors of the arrangement as shown in FIG. 2A. For example, the first pixel group 111 and the fourth pixel group 114 may correspond to green (G) light, the second pixel group 112 may correspond to blue (B) light, and the third pixel group 113 may correspond to red (R) light. Hereinafter, the first pixel group 111 may be interchangeably referred to as a first green pixel group, the second pixel group 112 may be interchangeably referred to as a blue pixel group, the third pixel group 113 may be interchangeably referred to as a red pixel group, and the fourth pixel group 114 may be interchangeably referred to as a second green pixel group. In addition, the first pixels 11 to 14 may be interchangeably referred to as first green pixels, the second pixels 21 to 24 may be interchangeably referred to as blue pixels, the third pixels 31 to 34 may be interchangeably referred to as red pixels, and the fourth pixels 41 to 44 may be interchangeably referred to as second green pixels.

Each of the pixels of the plurality of pixels PX may include a plurality of photosensitive cells that independently sense incident light. For example, as shown in FIG. 2B, one pixel PX may include two photosensitive cells. However, this is an example configuration, and embodiments of the present disclosure are not limited in this regard. That is, one pixel PX may be partitioned into a larger (e.g., three (3) or more) number of photosensitive cells. For example, one pixel PX may include photosensitive cells arranged in a 2×2 array. As another example, a plurality of independent photosensitive cells may be clustered and/or arranged in a 3×3 array and/or a 4×4 array.

The adjacent pixels PX and the plurality of photosensitive cells within the pixel PX may be electrically separated from each other by an isolation structure. Although shown as a line in the FIG. 2B, the isolation structure may have a physical thickness. The isolation structure may be formed as, for example, a deep trench isolation (DTI) structure. That is, a deep trench may be filled with air and/or an electrically insulating material. In an embodiment, a plurality of electrically separated cells may be formed by forming an optical sensing layer, and then forming the DTI structure on the optical sensing layer.

When one pixel PX includes the plurality of photosensitive cells, some of the plurality of pixels PX may be used as autofocus pixels. In an autofocus pixel, an autofocus signal may be obtained from a difference between output signals of adjacent photosensitive cells. For example, the autofocus signal may be generated from a difference between an output signal of a left photosensitive cell and an output signal of a right photosensitive cell.

Referring to FIG. 2C, the color separation lens array 130 includes a plurality of pixel correspondence regions each including nanoposts (not shown). The division of the regions of the color separation lens array 130 and the shape and arrangement of the nanoposts included in each region may be set to form a phase profile that separates incident light according to wavelengths and condenses the incident light to facing pixels. Hereinafter, color separation in a visible light band is described. However, embodiments of the present disclosure are not limited thereto. For example, a wavelength band may extend from a range of visible light to an infrared light range, and/or various other ranges.

The color separation lens array 130 includes a plurality of pixel correspondence groups 130G respectively corresponding to the plurality of unit pixel groups 110G of the sensor substrate 110 of FIG. 2B. For example, the pixel correspondence group 130G includes a first pixel correspondence region 131 facing the first pixel group 111, a second pixel correspondence region 132 facing the second pixel group 112, a third pixel correspondence region 133 facing the third pixel group 113, and a fourth pixel correspondence region 134 facing the fourth pixel group 114. The first to fourth pixel correspondence regions 131, 132, 133, and 134 may be interchangeably referred to as a first green pixel correspondence region, a blue pixel correspondence region, a red pixel correspondence region, and a second green pixel correspondence region, respectively.

Each of the first, second, third, and fourth pixel correspondence regions 131, 132, 133, and to 134 includes a plurality of nanoposts. Based on the shape and arrangement of the plurality of nanoposts, the incident light may be separated according to wavelengths, and multi-condensed onto pixels of the same color included in the sensor substrate 110. In some embodiments, the pixels may be continuously arranged.

As described with reference to FIGS. 2B and 2C, a structure in which pixels representing the same color form a group of four units in a 2×2 arrangement and in which each pixel PX includes two photosensitive cells may be referred to as a Tetra-2PD structure. In such a structure, the two photosensitive cells included in each pixel PX may only be used for generating the autofocus signal and may not be used as independent image pixels. However, embodiments of the present disclosure are not limited thereto. For example, the two photosensitive cells included in each pixel PX may be used for generating the autofocus signal and/or may be used as independent image pixels.

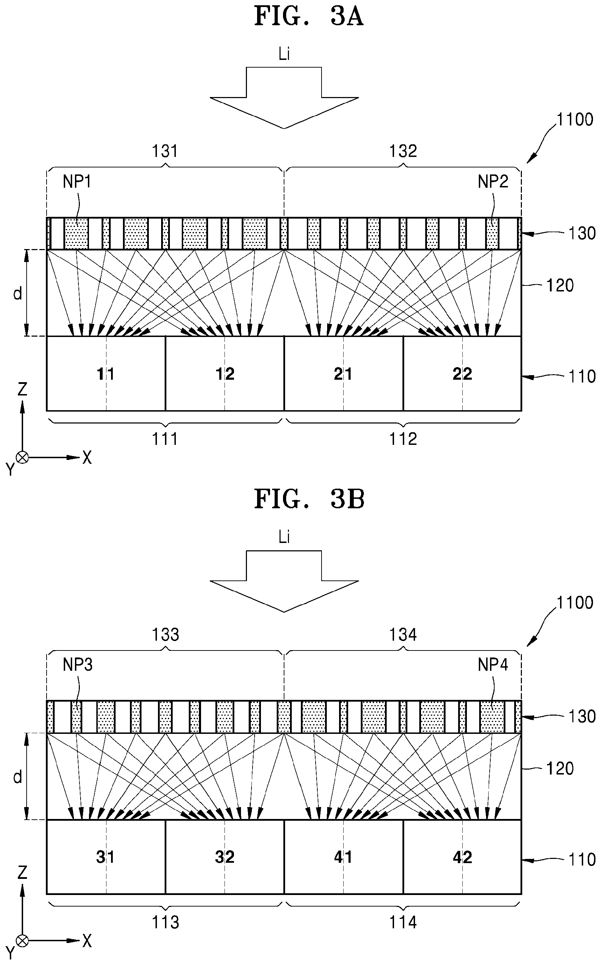

FIGS. 3A and 3B are different cross-sectional views of a pixel array of an image sensor according to an embodiment. FIG. 3A is the cross-sectional view of the pixel array taken along a line A-A' shown in FIG. 2C, and FIG. 3B is the cross-sectional view of the pixel array taken along a line B-B' shown in FIG. 2C.

Referring to FIGS. 3A and 3B, the pixel array 1100 of the image sensor 1000 includes the sensor substrate 110 and the color separation lens array 130 arranged on the sensor substrate 110.

As described with reference to FIG. 2B, the sensor substrate 110 may include the first pixel group 111, the second pixel group 112, the third pixel group 113, and the fourth pixel group 114, the first pixel group 111 may include the four first pixels 11, 12, 13, and 14, the second pixel group 112 may include the four second pixels 21, 22, 23, and 24, the third pixel group 113 may include the four third pixels 31, 32, 33, and 34, and the fourth pixel group 114 may include the four fourth pixels 41, 42, 43, and 44. Each of the first, second, third, and fourth pixels 11 to 14, 21 to 24, 31 to 34, and 41 to 44 may include two photosensitive cells that may independently sense light.

The color separation lens array 130 may include the first, second, third, and fourth pixel correspondence regions 131, 132, 133, and 134. The first pixel correspondence region 131 may include a plurality of first nanoposts NP1, the second pixel correspondence region 132 may include a plurality of second nanoposts NP2, the third pixel correspondence region 133 may include a plurality of third nanoposts NP3, and the fourth pixel correspondence region 134 may include a plurality of fourth nanoposts NP4.

Due to shapes and arrangement of the first, second, third, and fourth nanoposts NP1, NP2, NP3, and NP4, incident light may be separated according to wavelengths and condensed onto each of the first, second, third, and fourth pixels 111, 112, 113, and 114. In addition, light of the corresponding color may be multi-focused on the plurality of first pixels 11, 12, 13, and 14, the plurality of second pixels 21, 22, 23, and 24, the plurality of third pixels 31, 32, 33, and 34, and the plurality of fourth pixels 41, 42, 43, and 44 included in the first, second, third, and fourth pixel groups 111, 112, 113, and 114, respectively.

In an embodiment, from among light incident on the first pixel correspondence region 131 and its peripheral pixel correspondence regions, green light may be multi-condensed onto the four first pixels 11, 12, 13, and 14. From among light incident on the second pixel correspondence region 132 and its peripheral pixel correspondence regions, blue light may be multi-condensed onto the four second pixels 21, 22, 23, and 24. From among light incident on the third pixel correspondence region 133 and its peripheral pixel correspondence regions, red light may be multi-condensed onto the four third pixels 31, 32, 33, and 34. From among light incident on the fourth pixel correspondence region 134 and its peripheral pixel correspondence regions, green light may be multi-condensed onto the four fourth pixels 41, 42, 43, and 44.

That is, the arrangement of the first, second, third, and fourth nanoposts NP1, NP2, NP3, and NP4 of the first, second, third, and fourth pixel correspondence regions 131, 132, 133, and 134 may be set such that a phase profile suitable for such a light condensing distribution may be formed at a position immediately after the incident light passes through the color separation lens array 130.

Because a refractive index of a material varies depending on a wavelength of light, the color separation lens array 130 may provide different phase profiles with respect to different wavelength light. That is, because the same material may have a different refractive index according to the wavelength of light reacting with the material and a phase delay of the light that passes through the material may be different according to the wavelength, the phase profile may vary depending on the wavelength. For example, a refractive index of the first pixel correspondence region 131 with respect to the first wavelength light and a refractive index of the first pixel correspondence region 131 with respect to the second wavelength light may be different from each other. As such, the phase delay of the first wavelength light that passed through the first pixel correspondence region 131 and the phase delay of the second wavelength light that passed through the first pixel correspondence region 131 may be different from each other. Therefore, when the color separation lens array 130 is designed based on the characteristics of light, different phase profiles may be provided with respect to lights of different colors.

The plurality of first, second, third, and fourth nanoposts NP1, NP2, NP3, and NP4 included in the color separation lens array 130 may be arranged according to a certain rule to form different phase profiles with respect to light of a plurality of wavelengths. The rule may be applied to various parameters, such as, but not limited to, the shapes, sizes (e.g., width and height), distances, and the arrangement form of the first, second, third, and fourth nanoposts NP1, NP2, NP3, and NP4. In some embodiments, these parameters may be determined according to a phase profile to be implemented by the color separation lens array 130.

Hereinafter, the first, second, third, and fourth nanoposts NP1, NP2, NP3, and NP4 may be interchangeably referred to as nanoposts NP with respect to common matters of the first, second, third, and fourth nanoposts NP1, NP2, NP3, and NP4.

The nanoposts NP may have a shape dimension of a sub wavelength. As used herein, the sub wavelength may refer to a wavelength that is less than a wavelength band of light to be branched. The nanoposts NP may have a cylindrical shape having a cross-sectional diameter of a sub wavelength. However, the shape of the nanoposts NP is not limited thereto, and may be and/or may include, but not be limited to, an elliptical shape, a polygonal shape, and the like. In some embodiments, the nanoposts NP may have post shapes having symmetrical and/or asymmetrical cross-sectional shapes. The nanoposts NP shown in FIGS. 3A and 3B may have a constant width in the direction perpendicular to a height direction (Z-direction). That is, a cross-section parallel to the height direction may have a rectangular shape. However, the shape of the nanoposts PC depicted in FIGS. 3A and 3B may only be an example, and the present disclosure may not be limited in this regard. That is, the widths of the nanoposts NP in the direction perpendicular to the height direction may not be consistent. For example, the cross-section parallel to the height direction may have a trapezoidal shape and/or an inversed trapezoidal shape. When the incident light is a visible ray, the cross-sectional diameter of the nanoposts NP may be less than, for example, 400 nanometers (nm), 300 nm, or 200 nm. Alternatively or additionally, a height of the nanoposts NP may be about 500 nm to about 1500 nm, which may be greater than the cross-sectional diameter of the nanoposts NP. In an embodiment, the nanoposts NP may be obtained by combining two or more posts stacked in the height direction (Z direction). The height of the nanoposts NP may range from about a fraction of the wavelength (e.g., a sub wavelength) to about several times greater than the wavelength. For example, the height of the nanoposts NP may be about five times (5x), four times (4x), three times (3×) or less than a center wavelength of a wavelength band separated by the color separation lens array 130. Although the nanoposts NP in FIGS. 3A and 3B are shown as having a substantially similar and/or the same height, embodiments of the present disclosure are not limited thereto. The configuration of the nanoposts NP may be determined in consideration of detailed process conditions together with a phase profile for color separation.

A peripheral material having a refractive index that is different from that of the nanopost NP may be filled among the nanoposts NP. The nanoposts NP may include a material having a higher refractive index than a refractive index of a peripheral material. For example, the nanoposts NP may be and/or may include c-Si, p-Si, a-Si and a Group III-V compound semiconductor (e.g., gallium phosphide (GaP), gallium nitride (GaN), gallium arsenide (GaAs), and the like), silicon carbide (SiC), titanium dioxide (TiO₂), silicon nitride (SiN), and/or a combination thereof. The nanoposts NP having a different refractive index from the refractive index of the peripheral material may change the phase of light that passes through the nanoposts NP. The phase change may be caused by phase delay that may occur due to the shape dimension of the sub wavelength of the nanoposts NP, and a degree at which the phase is delayed, may be determined by a detailed shape dimension and arrangement shape of the nanoposts NP. A peripheral material of the nanoposts NP may be and/or may include a dielectric material having a lower refractive index than that of the nanoposts NP. For example, the peripheral material may be and/or may include, but not be limited to, silicon dioxide (SiO₂), air, and the like. However, embodiments of the disclosure are not limited thereto. That is, the materials of the nanoposts NP and the peripheral material may be set to various materials. Notably, the aspects presented herein may be employed with any materials so that the nanoposts NP may have a lower refractive index than that of the peripheral material.

In some embodiments, a transparent spacer layer 120 may be arranged between the sensor substrate 110 and the color separation lens array 130. The spacer layer 120 may support the color separation lens array 130 and may have a thickness d that may satisfy a requirement about a distance between the sensor substrate 110 and the color separation lens array 130. That is, thickness d that may satisfy a requirement about a distance between an upper surface of the sensor substrate 110 and a lower surface of the color separation lens array 130.

The spacer layer 120 may include a material transparent with respect to the visible ray, for example, a dielectric material having a lower refractive index than that of the nanoposts NP and having a low absorption coefficient in the visible ray band, such as, but not limited to, silicon dioxide (SiO₂), siloxane-based spin on glass (SOG), and the like. When the peripheral material layer filled among the nanoposts NP has a higher refractive index than that of the nanoposts NP, the spacer layer 120 may include a material having a lower refractive index than that of the peripheral material layer.

The thickness d of the spacer layer 120 (e.g., the distance between the lower surface of the color separation lens array 130 and the upper surface of the sensor substrate 110) may be determined with respect to a focal length of the light condensed by the color separation lens array 130. For example, the thickness d of the spacer layer 120 may be determined to be less than or equal to half (e.g., ½) of a focal length of green light. As another example, the thickness d of the spacer layer 120 may be determined to be about 70% to about 180% of a pitch of the pixel PX. Alternatively or additionally, multi-focusing efficiency between the pixels PX corresponding to the same color may be considered in setting the thickness d of the spacer layer 120. For example, when a color filter is provided between the sensor substrate 110 and the color separation lens array 130, the thickness d of the spacer layer 120 may become smaller considering the thickness and effective refractive index of the color filter.

In the embodiment, the shapes and arrangement of the first, second, third, and fourth nanoposts NP1, NP2, NP3, and NP4 respectively included in the first, second, third, and fourth pixel correspondence regions 131, 132, 133, and 134 of the color separation lens array 130 may be set such that a desired phase profile suitable for multi-condensing for each color is formed.

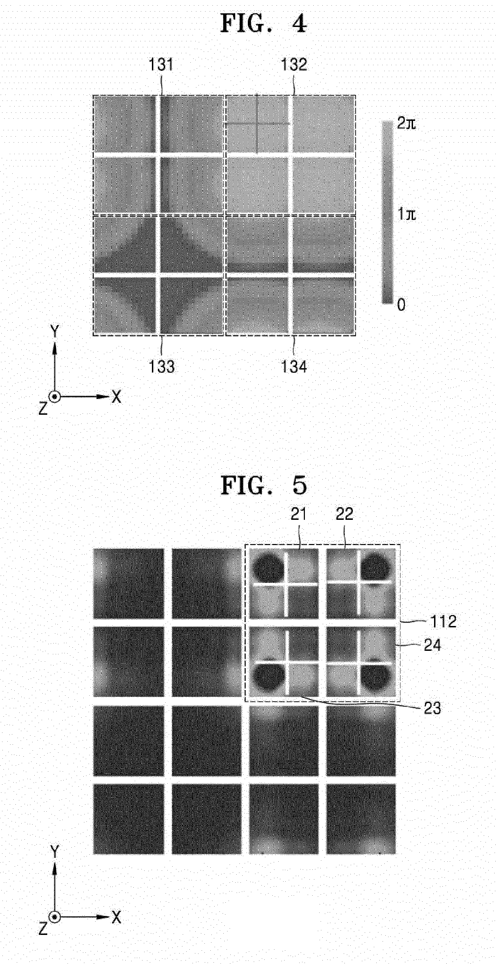

FIG. 4 is a diagram showing a phase profile of blue light immediately after passing through a color separation lens array included in a pixel array of an image sensor, according to an embodiment. FIG. 5 is a diagram showing a distribution in which the blue light of the phase profile shown in FIG. 4 is condensed onto blue pixels of a sensor substrate, according to an embodiment.

In the phase profile shown in FIG. 4, the second pixel correspondence region 132 may be sub-divided into regions (e.g., quarters) that may correspond to the four second pixels 21, 22, 23, and 24. In such an example, the center of each of the four regions may be a phase maximum point, and the phase may decrease toward the periphery of the second pixel correspondence region 132. The phase of the maximum point may be, for example, 2nπ, where n is a positive integer greater than zero (0). However, this is an example and embodiments of the present disclosure are not limited in this regard. For example, a maximum phase point of 2nπ may be a theoretical design value but may be less than 2nπ in actual application. As used herein, the maximum phase value may refer to the maximum value in the phase profile of a color light passing through a pixel correspondence region corresponding thereto, and the maximum point may refer to a position indicating the maximum phase value. The four areas in which the second pixel correspondence region 132 is divided into quarters may have a similar phase profile that may decrease concentrically with respect to the center of each region. In some embodiments, the phase may continue to decrease beyond the second pixel correspondence region 132. For example, the phase may reach a first minimum at a position corresponding to the center of the first pixel correspondence region 131 in a first direction (X direction), the phase may reach a second minimum at a position corresponding to the center of the fourth pixel correspondence region 134 in a second direction (Y direction), and the phase may reach a third minimum at a position corresponding to the center of the third pixel correspondence region 133 in a diagonal direction.

The condensing distribution of blue light illustrated in FIG. 5 may be obtained as a result of each blue light of the phase profile illustrated in FIG. 4 traveling toward the sensor substrate. Referring to FIG. 5, it may be seen that the blue light is multi-focused on the four second pixels 21, 22, 23, and 24 included in the second pixel group 112.

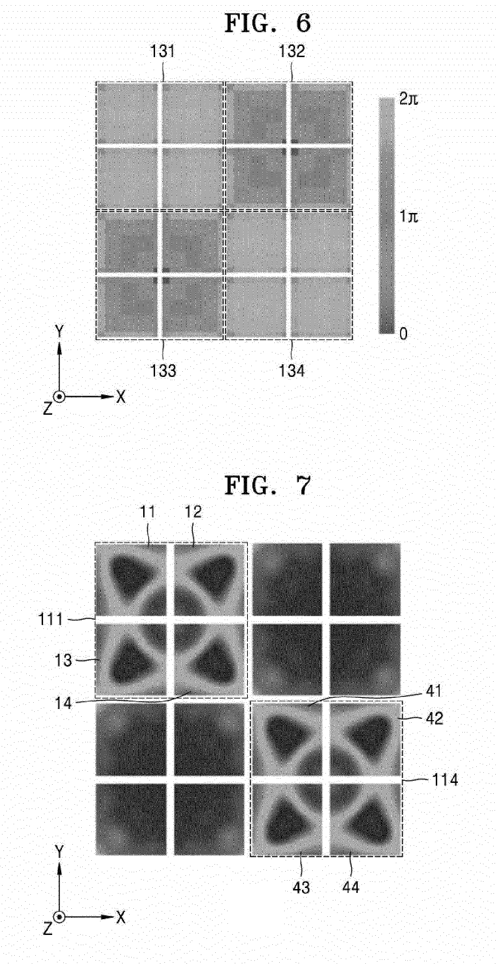

FIG. 6 is a diagram showing a phase profile of green light immediately after passing through a color separation lens array included in a pixel array of an image sensor, according to an embodiment. FIG. 7 is a diagram showing a distribution in which the green light of the phase profile shown in FIG. 6 is condensed onto green pixels of a sensor substrate, according to an embodiment.

In the phase profile shown in FIG. 6, a phase at the center of each of four regions where the first pixel correspondence region 131 is divided into quarters so as to correspond to the four first pixels 11 to 14 may be 2kπ, where k may be a positive integer greater than zero (0). The phase at the four regions of the first pixel correspondence region 131 may decrease toward the periphery of the first pixel correspondence region 131. Alternatively or additionally, a phase at the center of each of four regions, which may be sub-divided regions of the fourth pixel correspondence region 134 (e.g., quarters) that may correspond to the four fourth pixels 41 to 44, may be 2nπ, and the phase may decrease toward the periphery of the fourth pixel correspondence region 134. In such a phase profile, the phase may continue to decrease beyond the first pixel correspondence region 131 or the fourth pixel correspondence region 134. For example, the phase may reach a first minimum at a position corresponding to the center of the second pixel correspondence region 132 in a first direction (X direction), and the phase may reach a second minimum at a position corresponding to the center of the third pixel correspondence region 133 in a second direction (Y direction).

The condensing distribution of blue light illustrated in FIG. 7 may be obtained as a result of each green light of the phase profile illustrated in FIG. 6 traveling toward the sensor substrate 110. The green light may be multi-focused on the four first pixels 11, 12, 13, and 14 included in the first pixel group 111, and the four fourth pixels 41, 42, 43, and 44 included in the fourth pixel group 114.

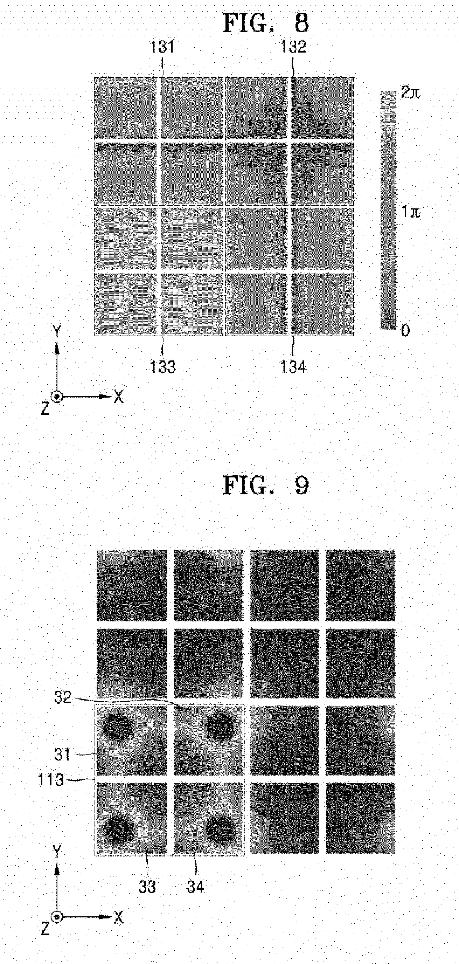

FIG. 8 is a diagram showing a phase profile of red light immediately after passing through a color separation lens array included in a pixel array of an image sensor, according to an embodiment. FIG. 9 is a diagram showing a distribution in which the red light of the phase profile shown in FIG. 8 is condensed onto red pixels of a sensor substrate, according to an embodiment.

In the phase profile shown in FIG. 8, a phase at the center of each of four regions, which may be sub-divided regions of the third pixel correspondence region 133 (e.g., quarters) that may correspond to the four third pixels 31, 32, 33, and 34, may be 2mπ, where m may be a positive integer greater than zero (0), and the phase may decrease toward the periphery of the third pixel correspondence region 133. The phase may continue to decrease beyond the third pixel correspondence region 133. For example, the phase may reach a first minimum at a position corresponding to the center of the fourth pixel correspondence region 134 in a first direction (X direction), the phase may reach a second minimum at a position corresponding to the center of the first pixel correspondence region 131 in a second direction (Y direction), and the phase may reach a third minimum at a position corresponding to the center of the second pixel correspondence region 132 in a diagonal direction.

The condensing distribution of red light illustrated in FIG. 9 may be obtained as a result of each green light of the phase profile illustrated in FIG. 8 traveling toward the sensor substrate 110. The red light may be multi-focused on the four third pixels 31, 32, 33, and 34 included in the third pixel group 113.

The phase profiles illustrated in FIGS. 4, 6, and 8 may be due to the first, second, third, and fourth nanoposts NP1, NP2, NP3, and NP4 included in the first, second, third, and fourth pixel correspondence regions 131, 132, 133, and 134 of the color separation lens array 130. That is, the first, second, third, and fourth nanoposts NP1, NP2, NP3, and NP4 of the color separation lens array 130 may be set for the phase profiles illustrated in FIGS. 4, 6, and 8 with respect to blue light, green light, and red light, and accordingly, a multi-condensing distribution for each color may appear.

Such a light condensing distribution may be a form in which light of the same color is diverged to a plurality of adjacent pixels displaying the same color, according to a designed phase profile. However, in some embodiments, it may be seen that the center of each of the condensing distributions illustrated in FIGS. 5, 7, and 9 may be deviated from the center of each pixel, which may cause a performance degradation of the image sensor 1000. For example, when performing autofocusing by utilizing a signal difference caused by two photosensitive cells included in one pixel, autofocusing may be complicated due to a difference between channels, or an autofocusing contrast ratio, that is, autofocusing sensitivity, may be lowered.

In another embodiment, in order to improve the condensing distribution, the phase profiles shown in FIGS. 4, 6, and 8 may be changed, and the first, second, third, and fourth nanoposts NP1, NP2, NP3, and NP4 may be set based on the phase profiles.

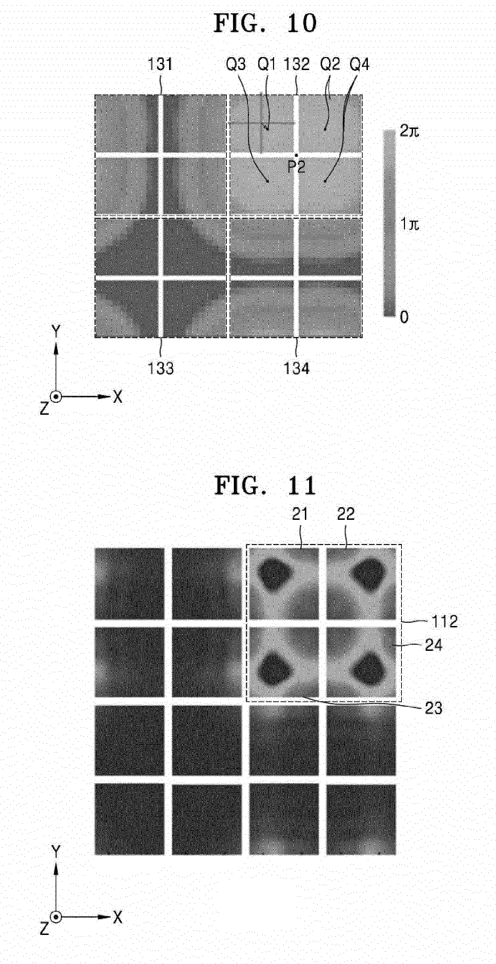

FIG. 10 is a diagram showing a phase profile of blue light immediately after passing through a color separation lens array included in a pixel array of an image sensor, according to an embodiment.

Upon comparing the phase profile of FIG. 10 with the phase profile illustrated in FIG. 4, four maximum points (e.g., first maximum point Q1, second maximum point Q2, third maximum point Q3, and fourth maximum point Q4) representing a phase maximum value (e.g., 2π) may not be aligned with the centers of the four second pixels 21, 22, 23, and 24 facing the second pixel correspondence region 132. For example, positions of the four maximum points Q1, Q2, Q3, and Q4 may be moved in a direction toward the center P2 of the second pixel correspondence region 132 from the centers of four sub regions where the second pixel correspondence region 132 is divided into quarters.

A similar phase profile change may also be applied to the phase profile of green light illustrated in FIG. 6 and the phase profile of red light illustrated in FIG. 8.

FIGS. 11 to 13 are diagrams respectively showing distributions of blue light, green light, and red light condensed onto a sensor substrate, according to such a phase profile change.

Upon comparing FIG. 11 with FIG. 5, in the distribution of the blue light multi-condensed onto the four second pixels 21, 22, 23, and 24, the center of each condensing distribution may be moved closer to the center of each of the second pixels 21, 22, 23, and 24.

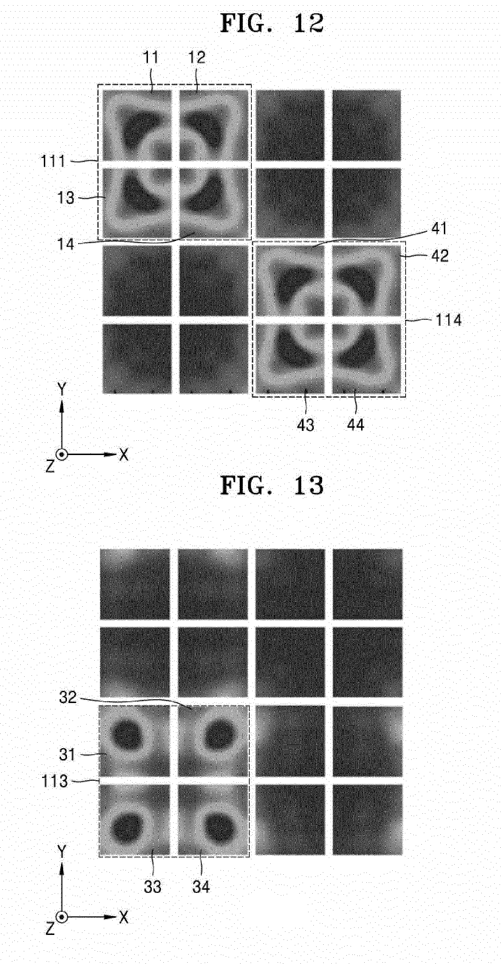

Similarly, the condensing distribution of the green light in FIG. 12 and the condensing distribution of the red light in FIG. 13 may also be changed, and the centering or symmetry of each condensing distribution may appear to be improved.

That is, it may be seen that in the setting of the first, second, third, and fourth nanoposts NP1, NP2, NP3, and NP4 included in the first, second, third, and fourth pixel correspondence regions 131, 132, 133, and 134, at positions immediately after passing through the color separation lens array 130, positions of a plurality of phase maximum points of each of the blue light phase profile, the green light phase profile, and the red light phase profile may be moved in a direction toward the center of each of the first, second, third, and fourth pixel correspondence regions 131, 132, 133, and 134, so that the condensing distribution may be improved to be advantageous to the performance of the image sensor 1000.

Although it has been described above that the blue light phase profile, the green light phase profile, and the red light phase profile are changed in a similar manner, in some embodiments, only one of blue light phase profile, the green light phase profile, and the red light phase profile may be changed. For example, the first, second, third, and fourth nanoposts NP1 to NP4 of the color separation lens array 130 may be designed such that the positions of the maximum points of the blue light phase profile deviate from the center of each of a plurality of sub regions included in a blue pixel correspondence region, and the positions of the maximum points of the red light phase profile are aligned with the center of each of a plurality of sub regions included in a red pixel correspondence region. Alternatively or additionally, the first, second, third, and fourth nanoposts NP1, NP2, NP3, and NP4 of the color separation lens array 130 may be designed in another phase profile combination.

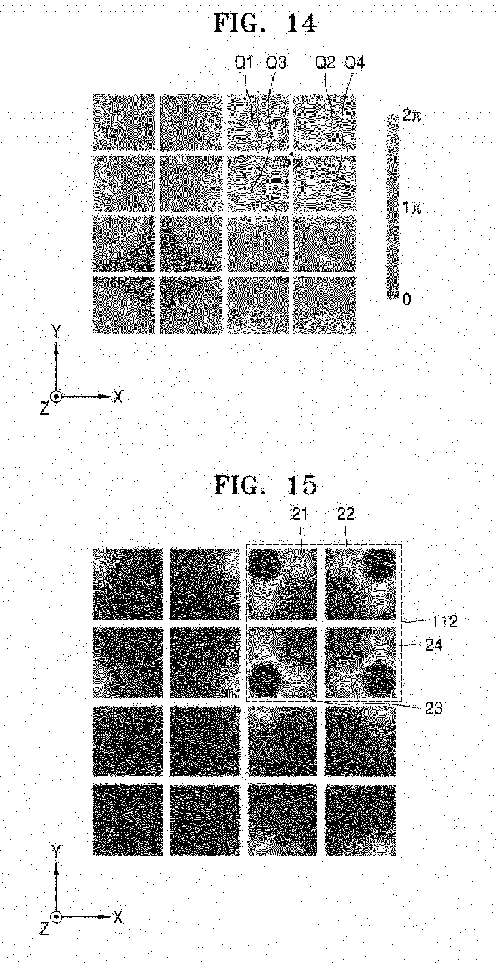

FIG. 14 is a diagram showing a phase profile of blue light immediately after passing through a color separation lens array included in a pixel array of an image sensor, according to an embodiment.

Upon comparing the phase profile of FIG. 14 with the phase profile illustrated in FIG. 4, the four maximum points Q1, Q2, Q3, and Q4 representing a phase maximum value (e.g., 2π) may not be aligned with the centers of the four second pixels 21, 22, 23, and 24 facing the second pixel correspondence region 132. Positions of the four maximum points Q1, Q2, Q3, and Q4 representing the phase maximum value may be moved in a direction away from the center P2 of the second pixel correspondence region 132 at the centers of four sub regions where the second pixel correspondence region 132 is divided into quarters.

A similar phase profile change may also be applied to the phase profile of green light illustrated in FIG. 6 and the phase profile of red light illustrated in FIG. 8.

FIGS. 15 to 17 are diagrams respectively showing distributions of blue light, green light, and red light condensed onto a sensor substrate when a phase profile of green light, and a phase profile of red light are changed in a manner similar to the phase profile of the blue light shown in FIG. 14, according to an embodiment.

Upon comparing FIG. 15 with FIG. 7, in the distribution of the blue light multi-condensed onto the four second pixels 21, 22, 23, and 24, the center of each condensing distribution may be moved further away from the center of each of the second pixels 21, 22, 23, and 24, and as such, the symmetry of the condensing distribution may be improved. This symmetry improvement may be seen as improved when compared to FIG. 11.

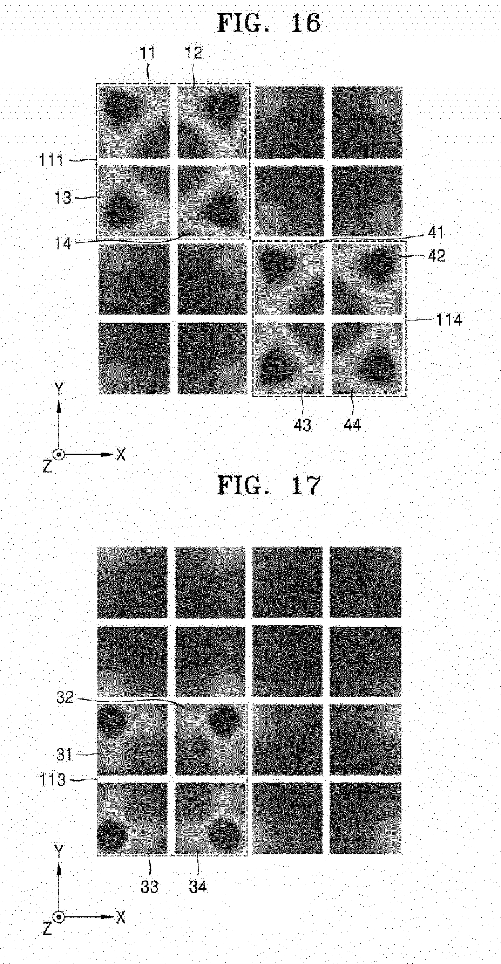

Similarly, the condensing distribution of green light in FIG. 16 and the condensing distribution of red light in FIG. 17 may also be changed, the center of each condensing distribution may be further away from the center of a facing pixel, but the symmetry of the condensing distribution may be improved. For example, it may be seen that the symmetry may be improved when compared to the cases of FIGS. 12 and 13.

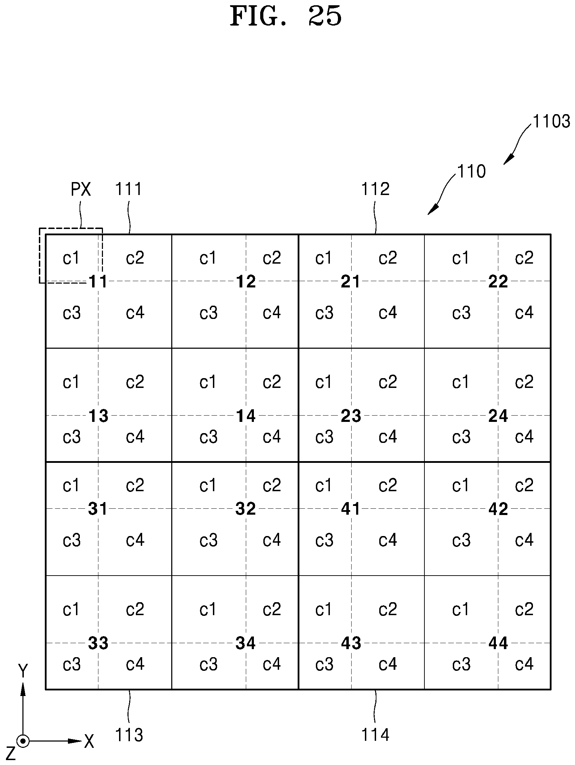

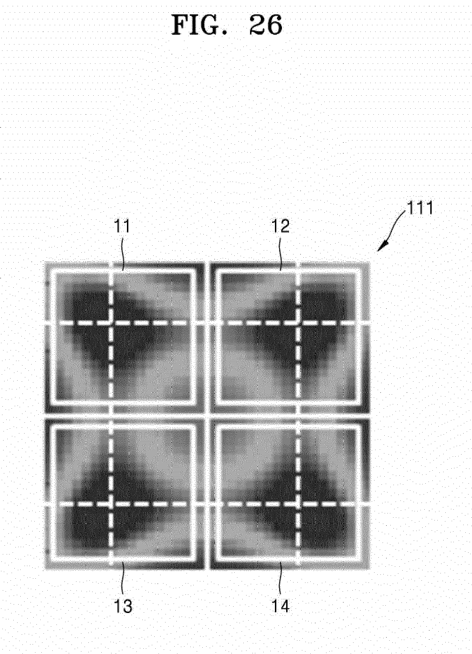

That is, it may be seen that in the setting of the first, second, third, and fourth nanoposts NP1, NP2, NP3, and NP4 included in the first, second, third, and fourth pixel correspondence regions 131, 132, 133, and 134, at positions immediately after passing through the color separation lens array 130, positions of a plurality of phase maximum points of each of the blue light phase profile, the green light phase profile, and the red light phase profile may be moved in a direction away from the center of each of the first, second, third, and fourth pixel correspondence regions 131, 132, 133, and 134, so that the symmetry of each condensing distribution may be improved. This form of phase profile change may be somewhat disadvantageous in terms of centering of the condensing distribution. However, because the symmetry of the condensing distribution is improved, the phase profile change may be used for improving autofocusing performance in combination with other designs. For example, in some embodiments, the phase profile change may be applied along with a design for differently setting cross-sectional areas of a plurality of photosensitive cells in the pixel, as described with reference to FIGS. 25 and 26.

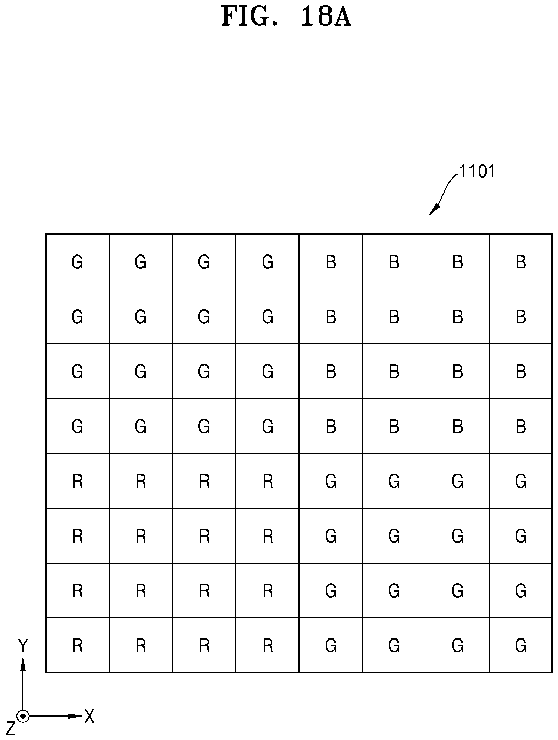

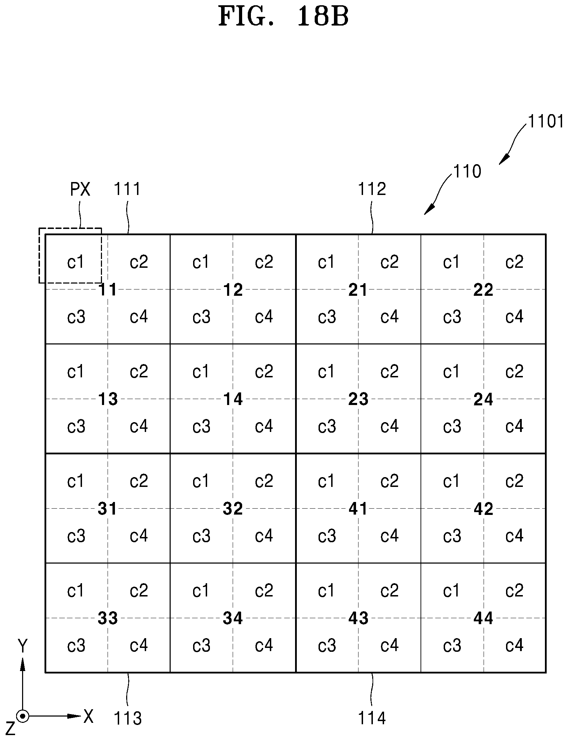

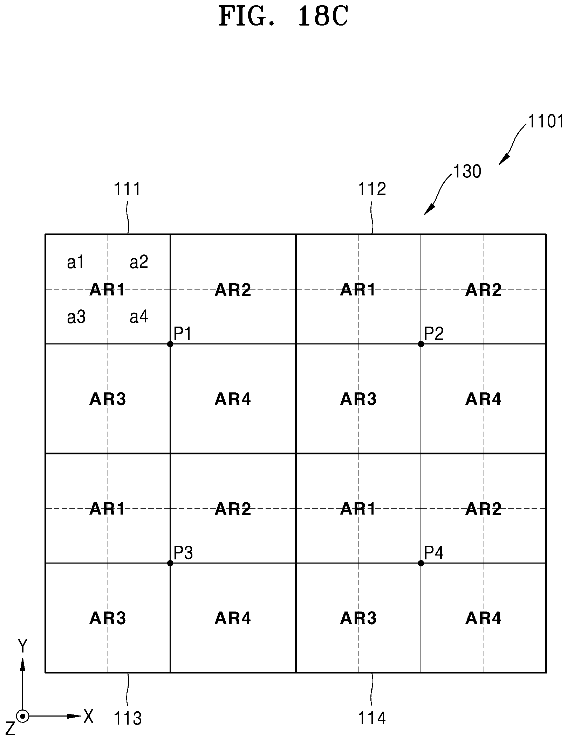

FIG. 18A is a plan view showing a color arrangement of a pixel array of an image sensor, according to an embodiment. FIGS. 18B and 18C are plan views showing a sensor substrate and a color separation lens array included in the pixel array of the image sensor, according to an embodiment.

The color arrangement of a pixel array 1101 of an image sensor in FIG. 18A may be similar in many respects to the Bayer pattern. However, the color arrangement may be different from the Bayer pattern in that the same colors may be adjacent to each other in a 4×4 arrangement and may also be different from the color arrangement shown in FIG. 2A. A 4×4 arrangement of green (G) color, a 4×4 arrangement of blue (B) color, a 4×4 arrangement of red (R) color, and a 4×4 arrangement of green (G) color may form a unit pattern, and the unit patterns may be repeatedly and/or two-dimensionally (2D) arranged in a first direction (X direction) and a second direction (Y direction). In FIG. 18A, only one unit pattern is shown for ease of description.

The pixel array 1101 may include the sensor substrate 110 having a pixel arrangement corresponding to such a color arrangement and the color separation lens array 130 condensing light of a color corresponding to a specific pixel. FIGS. 18B and 18C are plan views showing the sensor substrate 110 and the color separation lens array 130.

Referring to FIG. 18B, the sensor substrate 110 may include the plurality of pixels PX sensing incident light. The sensor substrate 110 may include the first pixel group 111, the second pixel group 112, the third pixel group 113, and the fourth pixel group 114. The first pixel group 111 may include the four first pixels 11, 12, 13, and 14 in a 2×2 arrangement, the second pixel group 112 may include the four second pixels 21, 22, 23, and 24 in a 2×2 arrangement, the third pixel group 113 may include the four third pixels 31, 32, 33, and 34 in a 2×2 arrangement, and the fourth pixel group 114 may include the four fourth pixels 41, 42, 43, and 44 in a 2×2 arrangement.

Each of the plurality of first pixels 11, 12, 13, and 14, each of the plurality of second pixels 21, 22, 23, and 24, each of the plurality of third pixels 31, 32, 33, and 34, and each of the plurality of fourth pixels 41, 42, 43, and 44 may also include a plurality of photosensitive cells (e.g., first photosensitive cell c1, second photosensitive cell c2, third photosensitive cell c3, and fourth photosensitive cell c4) independently sensing the incident light. Each of the photosensitive cells c1, c2, c3, and c4 may be used as an individual image pixel, that is, the basic unit pixel PX generating an image signal.

Some of the first, second, third, and fourth pixels 11 to 14, 21 to 24, 31 to 34, and 41 to 44 each including the photosensitive cells c1, c2, c3, and c4 may be used as autofocus pixels. An autofocus signal may be obtained from a difference between output signals of adjacent photosensitive cells within an autofocus pixel. For example, an autofocus signal in the first direction (X direction) may be generated from a difference between an output signal of the first photosensitive cell c1 and an output signal of the second photosensitive cell c2, a difference between an output signal of the third photosensitive cell c3 and an output signal of the fourth photosensitive cell c4, or a difference between the sum of the output signals of the first photosensitive cell c1 and the third photosensitive cell c3 and the sum of the output signals of the second photosensitive cell c2 and the fourth photosensitive cell c4. In addition, an autofocus signal in the second direction (Y direction) may be generated from a difference between the output signal of the first photosensitive cell c1 and the output signal of the third photosensitive cell c3, a difference between the output signal of the second photosensitive cell c2 and the output signal of the fourth photosensitive cell c4, or a difference between the sum of the output signals of the first photosensitive cell c1 and the second photosensitive cell c2 and the sum of the output signals of the third photosensitive cell c3 and the fourth photosensitive cell c4.

A general image signal may be obtained by using a sum mode and/or a full mode. In the sum mode, an image signal may be obtained by summing the output signals of the first, second, third, and fourth photosensitive cells c1, c2, c3, and c4. For example, a first green image signal may be generated by summing the output signals of the four photosensitive cells c1, c2, c3, and c4 belonging to each of the plurality of first pixels 11, 12, 13, and 14. Alternatively or additionally, the first green image signal may be generated by summing the output signals of two of the four photosensitive cells c1, c2, c3, and c4. Similarly, with respect to the plurality of second pixels 21, 22, 23, and 24 and the plurality of third pixels 31, 32, 33, and 34, a blue image signal and a red image signal may be generated by summing a portion (e.g., all or some) of the output signals of the four photosensitive cells c1, c2, c3, and c4. In the full mode, each of the photosensitive cells c1, c2, c3, and c4 included in each of the plurality of first pixels 11, 12, 13, and 14, each of the plurality of second pixels 21, 22, 23, and 24, each of the plurality of third pixels 31, 32, 33, and 34, and each of the plurality of fourth pixels 41, 42, 43, and 44 may be used as an individual pixel to obtain each output signal. In such a case, a high resolution image may be obtained.

Referring to FIG. 18C, the color separation lens array 130 may include a plurality of pixel correspondence regions, and nanoposts (not shown) are included in each region. The color separation lens array 130 may include the first pixel correspondence region 131 facing the first pixel group 111, the second pixel correspondence region 132 facing the second pixel group 112, the third pixel correspondence region 133 facing the third pixel group 113, and the fourth pixel correspondence region 134 facing the fourth pixel group 114.

The color separation lens array 130 is configured to multi-condense green light onto the plurality of first pixels 11, 12, 13, and 14 included in the first pixel group 111, multi-condense blue light onto the plurality of second pixels 21, 22, 23, and 24 included in the second pixel group 112, multi-condense red light onto the plurality of third pixels 31, 32, 33, and 34 included in the third pixel group 113, and multi-condense green light onto the plurality of fourth pixels 41, 42, 43, and 44 included in the fourth pixel group 114 shown in FIG. 18B.

The first pixel correspondence region 131 may include a plurality of sub regions (e.g., first sub region AR1, second sub region AR2, third sub region AR3, and fourth sub region AR4). The plurality of sub regions AR1, AR2, AR3, and to AR4 may have a one-to-one correspondence with the plurality of first pixels 11, 12, 13, and 14 and each sub region may face a corresponding pixel of the plurality of first pixels 11, 12, 13, and 14, as shown in FIG. 18B. Each of the plurality of sub regions AR1, AR2, AR3, and AR4 may include a plurality of basic regions (e.g., first basic region a1, second basic region a2, third basic region a3, and fourth basic region a4). Each of the plurality of basic regions a1, a2, a3, and a4 may have a one-to-one correspondence with the photosensitive cells c1 to c4 and each basic region may face a corresponding photosensitive cell of the plurality of photosensitive cells c1, c2, c3, and c4 included in each of the plurality of first pixels 111.

The second pixel correspondence region 132, the third pixel correspondence region 133, and the fourth pixel correspondence region 134 may also be partitioned in a manner similar to that of the first pixel correspondence region 131.

The division of the first, second, third, and fourth pixel correspondence regions 131, 132, 133, and 134 may be for the convenience of designing a nanopost arrangement for a phase profile to multi-condense light of the same color in multiple positions for each color to be implemented by the color separation lens array 130. The shapes and arrangement of the nanoposts disposed in the first, second, third, and fourth pixel correspondence regions 131, 132, 133, and 134 may be determined regardless of the division of regions.

When setting the detailed shapes and arrangement of the nanoposts disposed in the first, second, third, and fourth pixel correspondence regions 131, 132, 133, and 134, the phase profiles for each color and the condensing distributions corresponding thereto described with reference to FIGS. 4 to 17 may be considered. When designing the phase profile for each color, a similar phase profile may be repeated in units of each of the sub regions AR1, AR2, AR3, and AR4 of the first, second, third, and fourth pixel correspondence regions 131, 132, 133, and 134, For example, each of the sub regions AR1, AR2, AR3, and AR4 may include a phase maximum point with respect to a corresponding color.

The centers of the sub regions AR1, AR2, AR3, and AR4 included in the second pixel correspondence region 132 may coincide with positions of phase maximum points in a blue light phase profile. Alternatively or additionally, a phase profile may have the positions of the maximum phase points closer to the center P2 of the second pixel correspondence region 132. In some embodiments, a phase profile may have the positions of the maximum phase points away from the center C2 of the second pixel correspondence region 132. In the design of the first pixel correspondence region 131, the third pixel correspondence region 133, and the fourth pixel correspondence region 134, in a similar manner, the position of the phase maximum point appearing in each sub region may be considered in relation to a center P1 of the correspondence region 131, a center P3 of the third pixel correspondence region 133, and a center P4 of the fourth pixel correspondence region 134.

As described with reference to FIGS. 18B and 18C, a plurality of pixels representing the same color may be continuously arranged in a 2×2 shape to form a pixel group, light of the same color may be multi-condensed onto the plurality of pixels, and each pixel may have a 2×2 structure in which each pixel may include four photosensitive cells arranged the 2×2 shape that may be referred to as a Tetra-Qcell structure. In such a structure, four photosensitive cells included in each of the plurality of first, second, third, and fourth pixels 11 to 14, 21 to 24, 31 to 34, and 41 to 44 may be used for generating an autofocus signal, and the structure may be distinguished from the Tetra-2PD structure described with reference to FIGS. 2B and 2C in that the four photosensitive cells may also be used as the image pixels PX in an individual unit.

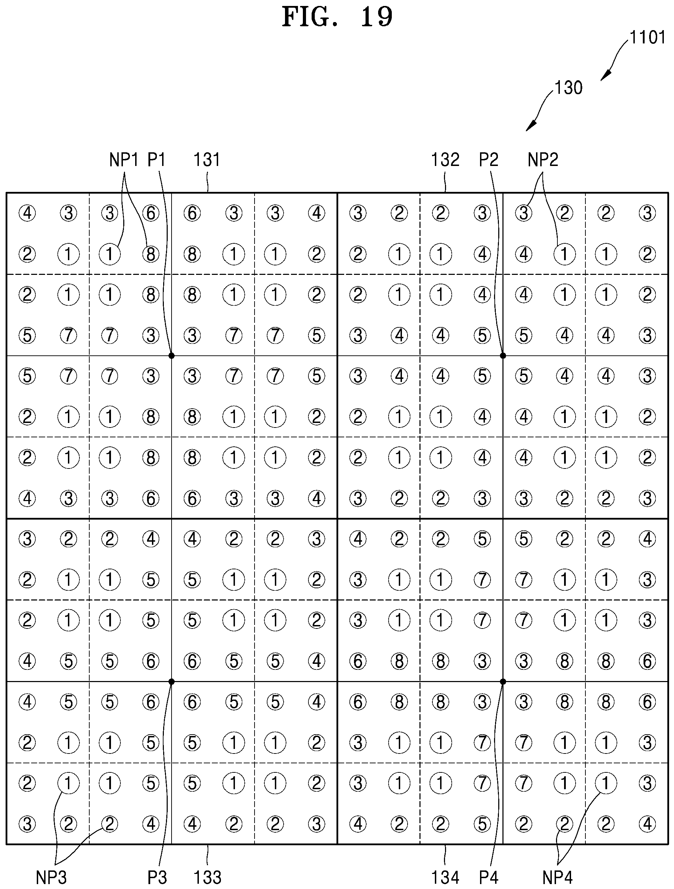

FIG. 19 is a plan view showing a configuration of a color separation lens array included in a pixel array of an image sensor, according to an embodiment.

The color separation lens array 130 may include the first, second, third, and fourth pixel correspondence regions 131, 132, 133, and 134, and the first, second, third, and fourth pixel correspondence regions 131, 132, 133, and 134 may respectively include a plurality of first, second, third, and fourth nanoposts NP1, NP2, NP3, and NP4.

The plurality of first, second, third, and fourth nanoposts NP1, NP2, NP3, and NP4 may separate incident light according to wavelengths, as shown in FIG. 18B, respectively condense the incident light onto the first, second, third, and fourth pixel groups 111, 112, 113 and 114 according to wavelengths, and multi-focus light of the corresponding color on the plurality of first pixels 11, 12, 13, and 14, the plurality of second pixels 21, 22, 23, and 24, the plurality of third pixels 31, 32, 33, and 34, and the plurality of fourth pixels 41, 42, 43, and 44 respectively included in the first, second, third, and fourth pixel groups 111, 112, 113, and 114. That is, from among the light incident on the first pixel correspondence region 131 and its peripheral pixel correspondence regions, green light may be multi-condensed onto the four first pixels 11, 12, 13, and 14, from among the light incident on the second pixel correspondence region 132 and its peripheral pixel correspondence regions, blue light may be multi-condensed onto the four second pixels 21, 22, 23, and 24, from among the light incident on the third pixel correspondence region 133 and its peripheral pixel correspondence regions, red light may be multi-condensed onto the four third pixels 31, 32, 33, and 34, and from among the light incident on the fourth pixel correspondence region 134 and its peripheral pixel correspondence regions, green light may be multi-condensed onto the four fourth pixels 41, 42, 43, and 44. The arrangement of the first, second, third, and fourth nanoposts NP1, NP2, NP3, and NP4 of the first, second, third, and fourth pixel correspondence regions 131, 132, 133, and 134 may be set such that a phase profile suitable for such a condensing distribution may be formed at a position immediately after the incident light passes through the color separation lens array 130.

In the second pixel correspondence region 132, the plurality of second nanoposts NP2 may be arranged symmetrically with respect to a diagonal line of a cross-section of the second pixel correspondence region 132. In the third pixel correspondence region 133, the plurality of third nanoposts NP3 may be arranged symmetrically with respect to a diagonal line of a cross-section of the third pixel correspondence region 133.

The plurality of first nanoposts NP1 of the first pixel correspondence region 131 and the plurality of fourth nanoposts NP4 of the fourth pixel correspondence region 134 may not have symmetry in a diagonal direction. However, embodiments of the present disclosure are not limited thereto. The plurality of first nanoposts NP1 of the first pixel correspondence region 131 may have symmetry with respect to a central horizontal line and symmetry with respect to a central vertical line in the cross-section of the first pixel correspondence region 131. The fourth pixel correspondence region 134 may also have symmetry similar to that of the first pixel correspondence region 131. The first pixel correspondence region 131 and the fourth pixel correspondence region 134 may be 90 degrees rotationally symmetrical with each other.

According to numbers indicated in the first, second, third, and fourth nanoposts NP1, NP2, NP3, and NP4 of the first, second, third, and fourth pixel correspondence regions 131, 132, 133, and 134, types of nanoposts with the same cross-sectional size in the same region are represented. That is, nanoposts marked with different numbers in the same region may have different cross-sectional sizes. However, embodiments of the present disclosure are not limited thereto, and nanoposts indicated by different numbers may have the same cross-sectional size. The division of regions indicated in the first, second, third, and fourth pixel correspondence regions 131, 132, 133, and 134 may be the same as that described with reference to FIG. 18C.

Four second nanoposts NP2 indicated by ① may be disposed in the center of each of the plurality of sub regions AR1, AR2, AR3, and AR4 of the second pixel correspondence region 132, and cross-sectional sizes of the four second nanoposts NP2 may be larger than cross-sectional sizes of the second nanoposts NP2 disposed in the periphery of each of the plurality of sub regions AR1, AR2, AR3, and AR4.

Four third nanoposts NP3 indicated by ① may also be disposed in the center of each of the plurality of sub regions AR1, AR2, AR3, and AR4 in which the third pixel correspondence region 133 is partitioned, and cross-sectional sizes of the third nanoposts NP3 may be larger than cross-sectional sizes of the third nanoposts NP3 disposed in the periphery of each of the plurality of sub regions AR1, AR2, AR3, and AR4.

Four first nanoposts NP1 having larger cross-sectional sizes than those of the first nanoposts NP1 in the periphery may be also disposed in the center of each of the four sub regions AR1, AR2, AR3, and AR4 in which the first pixel correspondence region 131 is partitioned, and four fourth nanoposts NP4 having larger cross-sectional sizes than those of the fourth nanoposts NP4 in the periphery may be also disposed in the center of each of the four sub regions AR1, AR2, AR3, and AR4 in which the fourth pixel correspondence region 134 is partitioned.

The first, second, third, and fourth nanoposts NP1, NP2, NP3, and NP4 disposed in the centers of the sub regions AR1, AR2, AR3, and AR4 belonging to different pixel correspondence regions may be indicated by ① and illustrated in the same size, but may have different cross-sectional sizes in actual application.

Each of the first, second, third, and fourth pixel correspondence regions 131, 132, 133, and 134 may include a plurality of regions partitioned in the same number as the number of a plurality of photosensitive cells facing each other. Each of the sub regions AR1, AR2, AR3, and AR4 may include basic regions a1, a2, a3, and a4, and four nanoposts having two or more types of cross-sectional sizes may be disposed in each of the basic regions a1, a2, a3, and a4. In FIG. 19, the four nanoposts having three or more types of cross-sectional sizes may be disposed in each of the basic regions a1, a2, a3, and a4. However, embodiments of the present disclosure are not limited in this regard, and the nanoposts may be disposed in a different configuration without departing from the scope of the present disclosure.

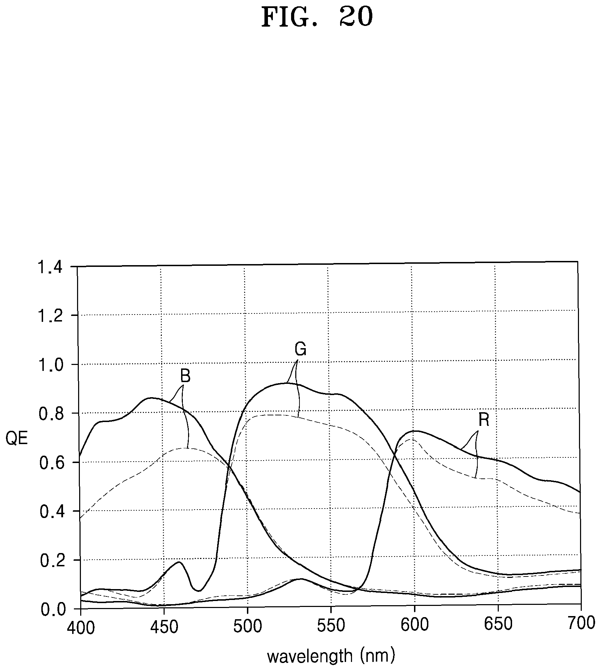

FIG. 20 is a graph showing quantum efficiency (QE) of an image sensor for each wavelength, according to an embodiment.

R, G, and B indicated by solid lines may relate to an image sensor according to the present disclosure, and R, G, and B indicated by dotted lines may relate to a related image sensor that may not include a color separation lens array. As shown in FIG. 20, the image sensor 1000 may exhibit an improved quantum efficiency when compared to a related image sensor.

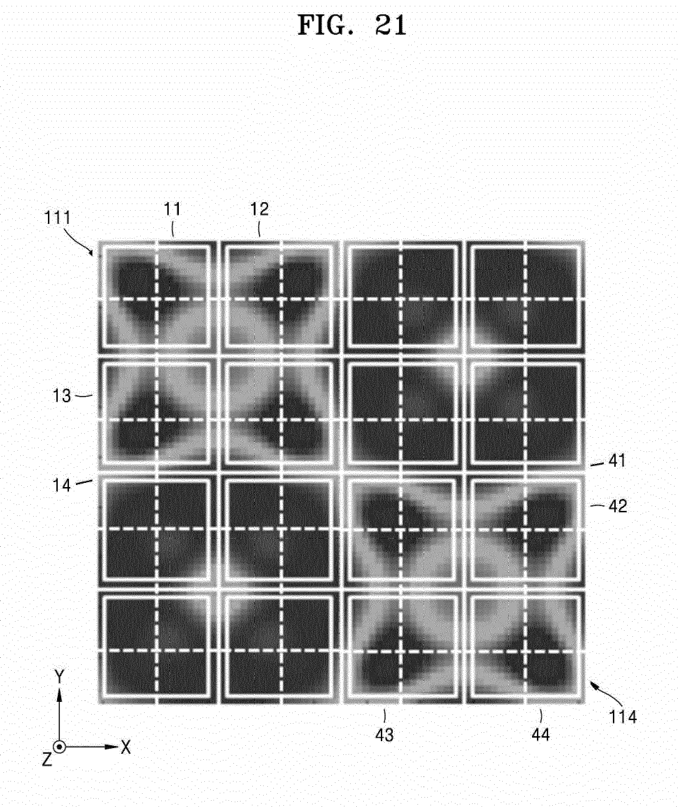

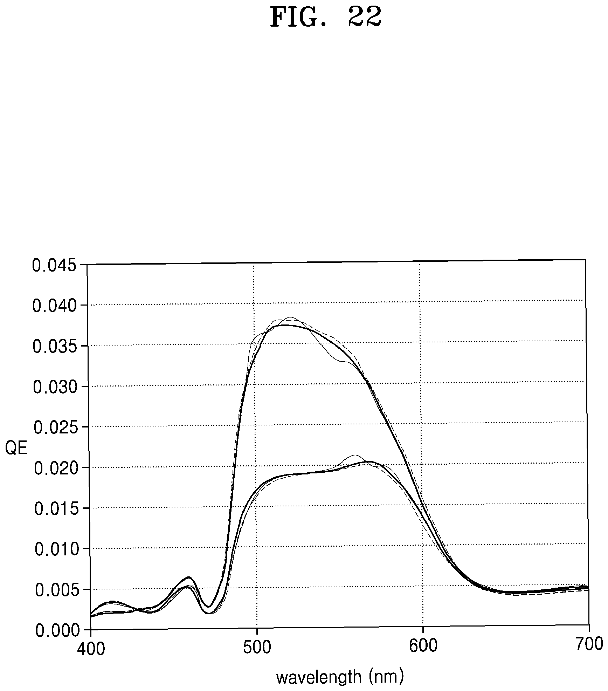

FIG. 21 is a diagram showing a distribution of green light condensed onto green pixels of a sensor substrate of a pixel array of an image sensor according to an embodiment. FIG. 22 is a graph showing optical signals in a plurality of channels of green pixels in an image sensor, according to an embodiment.

Referring to FIG. 21, green light may be multi-focused on the four first pixels 11, 12, 13, and 14 and the four fourth pixels 41, 42, 43, and 44. Light condensing distributions of the four first pixels 11, 12, 13, and 14 and the four fourth pixels 41, 42, 43, and 44 may be similar to each other, but the center of each condensing distribution may not be located at the center of each pixel. Accordingly, light condensing distributions in four photosensitive cells in which the four first pixels 11, 12, 13, and 14 and the four fourth pixels 41, 42, 43, and 44 are partitioned may differ in at least some respects. Consequently, different optical signals may be obtained for each channel even within the same pixel.

As shown in FIG. 22, there may be a difference in light efficiency of a plurality of channels belonging to the same green pixel.

In another embodiment, the condensing distributions shown in FIG. 21 and the difference in light efficiency for each channel of FIG. 22 may be changed by using the method described above with reference to FIGS. 4 to 17.

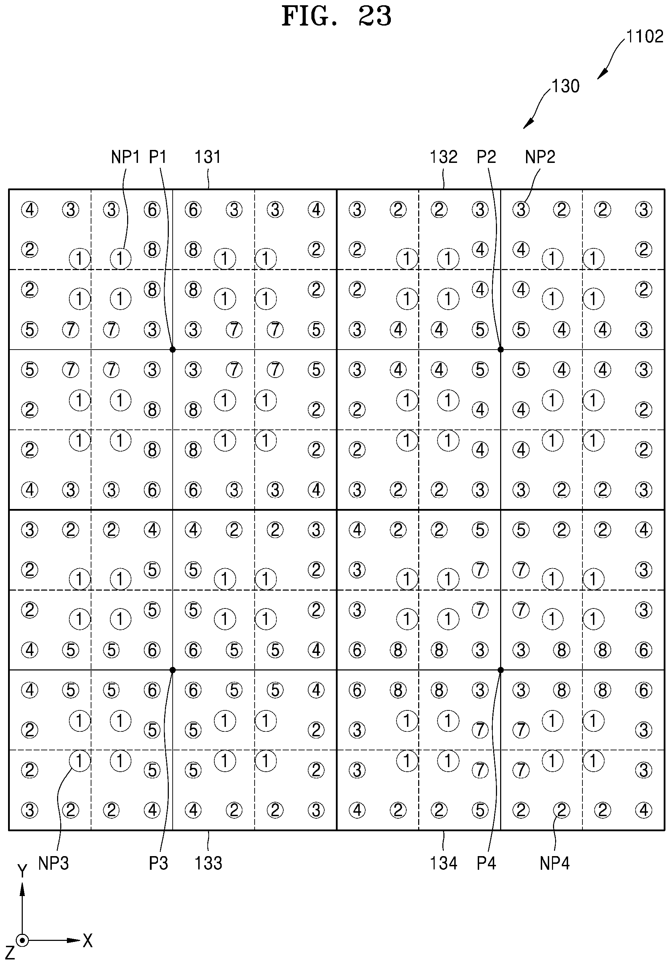

FIG. 23 is a plan view showing a configuration of a color separation lens array included in a pixel array of an image sensor, according to an embodiment.

The color separation lens array 130 included in the pixel array 1102 of the present embodiment may be different from FIG. 19 in positions of the first, second, third, and fourth nanoposts NP1, NP2, NP3, and NP4 disposed in the centers of the sub regions AR1, AR2, AR3, and AR4 of the first, second, third, and fourth pixel correspondence regions 131, 132, 133, and 134.

The center of an arrangement of the four second nanoposts NP2 respectively disposed in the centers of the sub regions AR1, AR2, AR3, and AR4 of the second pixel correspondence region 132 may be moved toward the center P2 of the second pixel correspondence region 132.

The nanoposts NP1, NP3, and NP4 disposed in the centers of the sub regions AR1, AR2, AR3, and AR4 of the first pixel correspondence region 131, the third pixel correspondence region 133, and the fourth pixel correspondence region 134 may also be respectively moved toward the center P1 of the pixel correspondence region 131, the center P3 of the third pixel correspondence region 133, and the center P4 of the fourth pixel correspondence region 134.

A position change of the first, second, third, and fourth nanoposts NP1, NP2, NP3, and NP4 may be related to a position change in a phase maximum point to the center of a pixel correspondence region as described with reference to FIG. 10. Accordingly, centering of each condensing distribution may be improved.

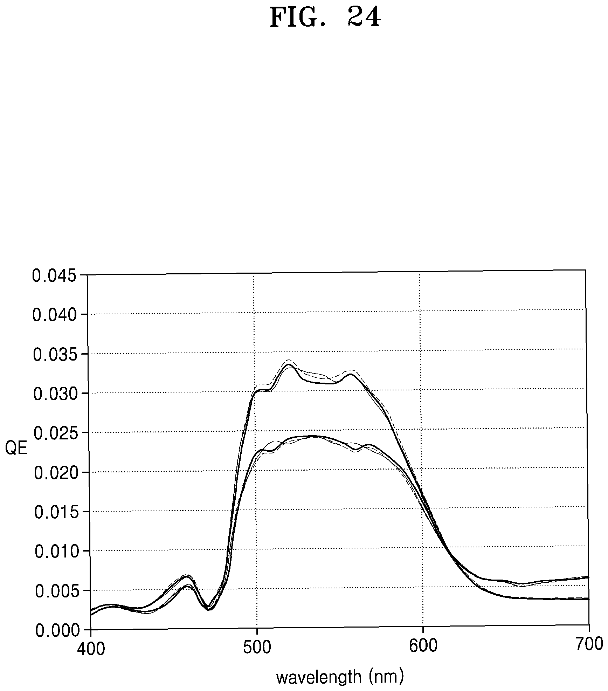

FIG. 24 is a graph showing optical signals in a plurality of channels of green pixels in an image sensor, according to an embodiment.

Referring to the graph, it may be seen that a difference in light efficiency for each channel may be reduced compared to the difference in light efficiency shown in the graph of FIG. 22.

Compared to FIG. 21, in the color separation lens array 130 of the pixel array 1102 of FIG. 23, the first, second, third, and fourth nanoposts NP1, NP2, NP3, and NP4 of the center of each of the sub regions AR1, AR2, AR3 and AR4 in the first, second, third, and fourth pixel correspondence regions 131, 132, 133, and 134 may be moved in a direction toward the center of each of the first, second, third, and fourth pixel correspondence regions 131, 132, 133, and 134. However, embodiments of the present disclosure are not limited thereto. In some embodiments, such a position movement may occur only in some of the first, second, third, and fourth pixel correspondence regions 131, 132, 133, and 134, and/or a position movement direction may be different.

FIG. 25 is a plan view showing a sensor substrate of a pixel array of an image sensor, according to an embodiment. FIG. 26 is a diagram showing a distribution of green light condensed onto green pixels illustrated in FIG. 25, according to an embodiment.

The sensor substrate 110 of the pixel array 1103 of the present embodiment may be different from the embodiments described above in that cross-sectional areas of four photosensitive cells respectively included in the first, second, third, and fourth pixels 11 to 14, 21 to 24, 31 to 34, and 41 to 44 may not be the same. The areas of at least two of the four photosensitive cells may be different from each other, and/or the areas of the four photosensitive cells may be different from each other.

Such a change of partition may consider a condensing distribution as shown in FIG. 26, and may reduce the area of a channel with a relatively large optical signal and may widen the area of a channel with a relatively small optical signal, thereby equalizing optical signals for each channel.

The present embodiment may be applied together with the color separation lens array 130 of the pixel array 1101 illustrated in FIG. 19 and/or the color separation lens array 130 of the pixel array 1102 illustrated in FIG. 23. Alternatively or additionally, a color separation lens array of a modified example in which a position of a central nanopost is changed may also be applied in a direction opposite to that of FIG. 23. As described with reference to FIGS. 14 to 17, changing a position of a phase maximum point of each of the sub regions AR1, AR2, AR3, and AR4 in a direction away from the center of the pixel correspondence region may be disadvantageous to centering of the condensing distribution but may improve the symmetry of the condensing distribution.

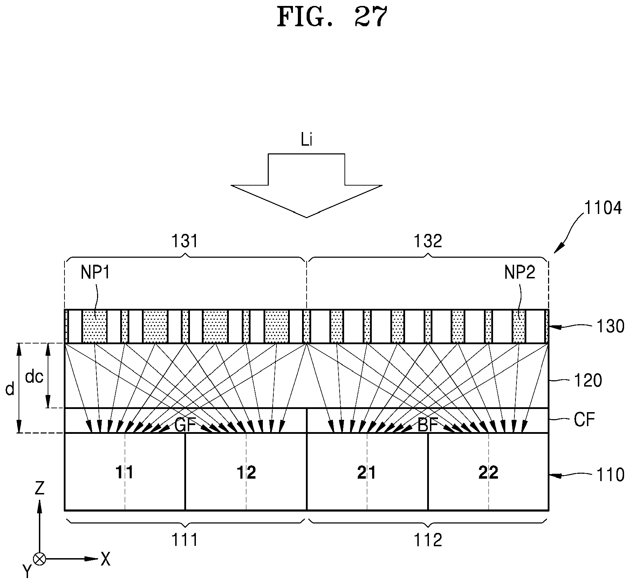

FIG. 27 is a cross-sectional view showing a pixel array of an image sensor, according to an embodiment.

FIG. 27 is a cross-sectional view of the pixel array taken along the line A-A' shown in FIG. 2C. A pixel array 1104 may include a color filter CF disposed between the sensor substrate 110 and the color separation lens array 130. The color filter CF may include a green filter GF and a blue filter BF respectively corresponding to the first and second pixel groups 111 and 112, and may include a red filter and a green filter respectively corresponding to the third and fourth pixel groups 113 and 114, shown in FIG. 2B.

Because light diverged according to wavelengths by the color separation lens array 130 may be incident on the color filter CF, a light efficiency reduction by the color filter CF may hardly occur, and a color purity may increase. In a case where the pixel array 1104 includes the color filter CF, an effective refractive index by the color filter CF and the spacer layer 120 may be considered when the distance d between the sensor substrate 110 and the color separation lens array 130 is set as described above. A distance dc between the color separation lens array 130 and the color filter CF may be appropriately set in consideration of the distance d determined as described above and a thickness of the color filter CF.

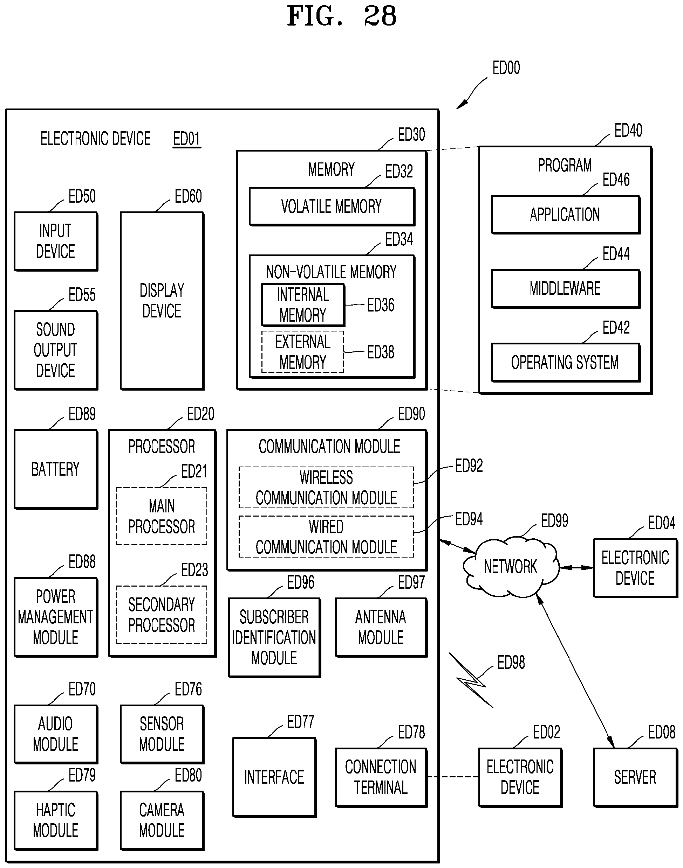

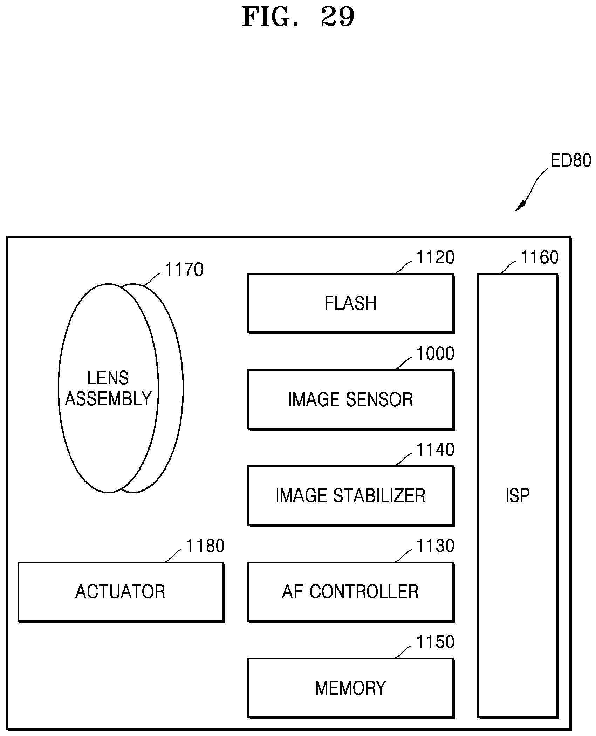

FIG. 28 is a schematic block diagram of an electronic apparatus including an image sensor according to some embodiments. FIG. 29 is a schematic block diagram of a camera module included in the electronic apparatus of FIG. 28.

Referring to FIG. 28, in a network environment ED00, the electronic apparatus ED01 may communicate with another electronic apparatus ED02 via a first network ED98 (e.g., short-range wireless communication network, and the like), or may communicate with another electronic apparatus ED04 and/or a server ED08 via a second network ED99 (e.g., long-range wireless communication network, and the like) The electronic apparatus ED01 may communicate with the electronic apparatus ED04 via the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic apparatus ED01, some (e.g., display device ED60, and the like) of the components may be omitted or another component may be added. Some of the components may be configured as one integrated circuit. For example, the sensor module ED76 (e.g., a fingerprint sensor, an iris sensor, an illuminance sensor, and the like) may be embedded and implemented in the display device ED60 (e.g., display, and the like)

The processor ED20 may control one or more components (e.g., hardware, software components, and the like) of the electronic apparatus ED01 connected to the processor ED20 by executing software (e.g., program ED40, and the like), and may perform various data processes or operations. As a part of the data processing or operations, the processor ED20 may load a command and/or data received from another component (e.g., sensor module ED76, communication module ED90, and the like) to a volatile memory ED32, may process the command and/or data stored in the volatile memory ED32, and may store result data in a non-volatile memory ED34. The processor ED20 may include a main processor ED21 (e.g., central processing unit, application processor, and the like) and an auxiliary processor ED23 (e.g., graphic processing unit, image signal processor, sensor hub processor, communication processor, and the like) that may be operated independently from or along with the main processor ED21. In some embodiments, the auxiliary processor ED23 may use less power than that of the main processor ED21, and may perform specific functions.

The auxiliary processor ED23, on behalf of the main processor ED21 while the main processor ED21 is in an inactive state (e.g., sleep state) or along with the main processor ED21 while the main processor ED21 is in an active state (e.g., application execution state), may control functions and/or states related to some (e.g., display device ED60, sensor module ED76, communication module ED90, and the like) of the components in the electronic apparatus ED01. The auxiliary processor ED23 (e.g., image signal processor, communication processor, and the like) may be implemented as a part of another component (e.g., camera module ED80, communication module ED90, and the like) that is functionally related thereto.

The memory ED30 may store various data required by the components (e.g., processor ED20, sensor module ED76, and the like) of the electronic apparatus ED01. The data may include, for example, input data and/or output data about software (e.g., program ED40, and the like) and commands related thereto. The memory ED30 may include the volatile memory ED32 and/or the non-volatile memory ED34.

The program ED40 may be stored as software in the memory ED30, and may include an operation system ED42, middleware ED44, and/or an application ED46.

The input device ED50 may receive commands and/or data to be used in the components (e.g., processor ED20, and the like) of the electronic apparatus ED01, from outside (e.g., user, and the like) of the electronic apparatus ED01. The input device ED50 may include a microphone, a mouse, a keyboard, and/or a digital pen (stylus pen).

The sound output device ED55 may output a sound signal to outside of the electronic apparatus ED01. The sound output device ED55 may include a speaker and/or a receiver. The speaker may be used for a general purpose such as multimedia reproduction or record play, and the receiver may be used to receive a call. The receiver may be coupled as a part of the speaker or may be implemented as an independent device.

The display device ED60 may provide visual information to outside of the electronic apparatus ED01. The display device ED60 may include a display, a hologram device, or a projector, and a control circuit for controlling the corresponding device. The display device ED60 may include a touch circuitry set to sense a touch, and/or a sensor circuit (e.g., pressure sensor, and the like) that is set to measure a strength of a force generated by the touch.

The audio module ED70 may convert sound into an electrical signal or vice versa. The audio module ED 70 may acquire sound through the input device ED50, or may output sound via the sound output device ED55 and/or a speaker and/or a headphone of another electronic apparatus (e.g., electronic apparatus ED02, and the like) connected directly or wirelessly to the electronic apparatus ED01.

The sensor module ED76 may sense an operating state (e.g., power, temperature, and the like) of the electronic apparatus ED01, or an outer environmental state (e.g., user state, and the like), and may generate an electrical signal and/or data value corresponding to the sensed state. The sensor module ED76 may include a gesture sensor, a gyro-sensor, a pressure sensor, a magnetic sensor, an acceleration sensor, a grip sensor, a proximity sensor, a color sensor, an infrared (IR) ray sensor, a vivo sensor, a temperature sensor, a humidity sensor, and/or an illuminance sensor.

The interface ED77 may support one or more designated protocols that may be used in order for the electronic apparatus ED01 to be directly or wirelessly connected to another electronic apparatus (e.g., electronic apparatus ED02, and the like) The interface ED77 may include a high-definition multimedia interface (HDMI), a universal serial bus (USB) interface, a secure digital (SD) card interface, and/or an audio interface.

The connection terminal ED78 may include a connector by which the electronic apparatus ED01 may be physically connected to another electronic apparatus (e.g., electronic apparatus ED02, and the like). The connection terminal ED78 may include an HDMI connector, a USB connector, an SD card connector, and/or an audio connector (e.g., headphone connector, and the like).

The haptic module ED79 may convert the electrical signal into a mechanical stimulation (e.g., vibration, motion, and the like) or an electric stimulation that the user may sense through a tactile or motion sensation. The haptic module ED79 may include a motor, a piezoelectric device, and/or an electric stimulus device.

The camera module ED80 may capture a still image and a video. The camera module ED80 may include a lens assembly including one or more lenses, the image sensor 1000 described above, image signal processors, and/or flashes. The lens assembly included in the camera module ED80 may collect light emitted from an object that is an object to be captured.

The power management module ED88 may manage the power supplied to the electronic apparatus ED01. The power management module ED88 may be implemented as a part of a power management integrated circuit (PMIC).

The battery ED89 may supply electric power to components of the electronic apparatus ED01. The battery ED89 may include a primary battery that may not be rechargeable, a secondary battery that may be rechargeable, and/or a fuel cell.

The communication module ED90 may support the establishment of a direct (wired) communication channel and/or a wireless communication channel between the electronic apparatus ED01 and another electronic apparatus (e.g., electronic apparatus ED02, electronic apparatus ED04, server ED08, and the like), and execution of communication through the established communication channel. The communication module ED90 may be operated independently from the processor ED20 (e.g., application processor, and the like), and may include one or more communication processors that support the direct communication and/or the wireless communication. The communication module ED90 may include a wireless communication module ED92 (e.g., cellular communication module, a short-range wireless communication module, a global navigation satellite system (GNSS) communication module) and/or a wired communication module ED94 (e.g., local area network (LAN) communication module, a power line communication module, and the like)). From among the communication modules, a corresponding communication module may communicate with another electronic apparatus via a first network ED09 (e.g., short-range communication network such as Bluetooth^{™}, Wireless Fidelity (WiFi) direct, or infrared data association (IrDA), and the like) or a second network ED99 (e.g., long-range communication network such as a cellular network, Internet, or computer network (LAN, WAN, and the like)). Such above various kinds of communication modules may be integrated as one component (e.g., single chip, and the like) or may be implemented as a plurality of components (e.g., a plurality of chips) separately from one another. The wireless communication module ED92 may identify and authenticate the electronic apparatus ED01 in a communication network such as the first network ED98 and/or the second network ED99 by using subscriber information (e.g., international mobile subscriber identifier (IMSI), and the like) stored in the subscriber identification module ED96.

The antenna module ED97 may transmit and/or receive the signal and/or power to/from outside (e.g., another electronic apparatus, and the like). An antenna may include a radiator formed as a conductive pattern formed on a substrate (e.g., PCB, and the like). The antenna module ED97 may include one or more antennas. When the antenna module ED97 includes a plurality of antennas, from among the plurality of antennas, an antenna that is suitable for the communication type used in the communication network such as the first network ED98 and/or the second network ED99 may be selected by the communication module ED90. The signal and/or the power may be transmitted between the communication module ED90 and another electronic apparatus via the selected antenna. Another component (e.g., RFIC, and the like) other than the antenna may be included as a part of the antenna module ED97.

Some of the components may be connected to one another via the communication method among the peripheral devices (e.g., bus, general purpose input and output (GPIO), serial peripheral interface (SPI), mobile industry processor interface (MIPI), and the like) and may exchange signals (e.g., commands, data, and the like).

The command or data may be transmitted and/or received between the electronic apparatus ED01 and the external electronic apparatus ED04 via the server ED08 connected to the second network ED99. Other electronic apparatuses ED02 and ED04 may be the devices that are the same as and/or different kinds from the electronic apparatus ED01. All or some of the operations executed in the electronic apparatus ED01 may be executed in one or more devices among the other electronic apparatuses ED02, ED04, and ED08. For example, when the electronic apparatus ED01 has to perform a certain function or service, the electronic apparatus ED01 may request one or more other electronic apparatuses to perform some or entire function or service, instead of executing the function or service by itself. One or more electronic apparatuses receiving the request may execute an additional function and/or service related to the request and may transfer a result of the execution to the electronic apparatus ED01. For example, a cloud computing, a distributed computing, or a client-server computing technique may be used.

Referring to FIG. 29, the camera module ED80 may include a lens assembly 1170, a flash 1120, an image sensor 1000, an image stabilizer 1140, an AF controller 1130, a memory 1150 (e.g., buffer memory, and the like), an actuator 1180, and/or an image signal processor (ISP) 1160.

The lens assembly 1170 may collect light emitted from an object that is to be captured. The lens assembly 1170 may include one or more optical lenses. The lens assembly 1170 may include a path switching member which switches the optical path toward the image sensor 1000. According to whether the path switching member is provided and the arrangement type with the optical lens, the camera module ED80 may have a vertical type or a folded type. The camera module ED80 may include a plurality of lens assemblies 1170, and in this case, the camera module ED80 may include a dual camera module, a 360-degree camera, and/or a spherical camera. Some of the plurality of lens assemblies 1170 may have the same lens properties (e.g., viewing angle, focal distance, autofocus, F-stop number, optical zoom, and the like) and/or different lens properties. The lens assembly 1170 may include a wide-angle lens and/or a telephoto lens.

The actuator 1180 may drive the lens assembly 1170. At least some of the optical lens and the path switching member included in the lens assembly 1170 may be moved by the actuator 1180. The optical lens may be moved along the optical axis, and when the distance between adjacent lenses is adjusted by moving at least some of the optical lenses included in the lens assembly 1170, an optical zoom ratio may be adjusted.

The actuator 1180 may adjust the position of any one of the optical lenses in the lens assembly 1170 so that the image sensor 1000 may be located at the focal length of the lens assembly 1170. The actuator 1180 may drive the lens assembly 1170 according to an AF driving signal transferred from the AF controller 1130.

The flash 1120 may emit light that may be used to strengthen the light emitted and/or reflected from the object. The flash 1120 may emit visible light and/or infrared-ray light. The flash 1120 may include, but not be limited to, one or more light-emitting diodes (e.g., red-green-blue (RGB) light-emitting diode (LED), white LED, infrared LED, ultraviolet LED, and the like), and/or a Xenon lamp.

The image sensor 1000 may be and/or may include the image sensor 1000 described above with reference to FIG. 1. That is, any one of the above-described pixel arrays 100, 1101, 1102, 1103, and 1104 having various color separation lens arrays, or a combination or modified structure thereof. The image sensor 1000 may obtain an image corresponding to a subject by converting the light emitted or reflected from the subject and transferred through the lens assembly 1170 into an electrical signal.

As described above, the image sensor 1000 may include a color separation lens array in which shapes and arrangement of nanoposts are set, to increase light efficiency and reduce resolution deterioration, and thus, the obtained image quality may be improved. Such an image quality improvement effect may be better achieved when the camera module ED80 is a telephoto camera, that is, when the lens assembly 1170 is a telephoto lens. As described above, the image sensor 1000 may include a plurality of photosensitive cells in which pixels representing the same color form a plurality of channels. Some of the pixels may be used as AF pixels, and the image sensor 1000 may generate an AF driving signal from the signals from the plurality of channels in the AF pixels. In the color separation lens array included in the image sensor 1000, the size and arrangement of the nanoposts may be designed so that an optical signal difference for each channel may be small, and the accuracy of AF driving may be improved.

The image stabilizer 1140, in response to a motion of the camera module ED80 and/or the electronic apparatus ED01 including the camera module ED80, may move one or more lenses included in the lens assembly 1170 and/or the image sensor 1000 in a certain direction or may control the operating characteristics of the image sensor 1000 (e.g., adjusting of a read-out timing, and the like) in order to compensate for a negative influence of the motion. The image stabilizer 1140 may sense the movement of the camera module ED80 and/or the electronic apparatus ED01 by using a gyro sensor or an acceleration sensor arranged in or out of the camera module ED80. The image stabilizer 1140 may be implemented as an optical type.

The AF controller 1130 may generate the AF driving signal from signal values sensed from the AF pixels in the image sensor 1000. The AF controller 1130 may control the actuator 1180 according to the AF driving signal.

The memory 1150 may store some or entire data of the image obtained through the image sensor 1000 for next image processing operation. For example, when a plurality of images are obtained at a high speed, obtained original data (e.g., Bayer-patterned data, high resolution data, and the like) may be stored in the memory 1150, and only a low resolution image may be displayed. Subsequently, original data of a selected image (e.g., user selection, and the like) may be transferred to the image signal processor 1160. The memory 1150 may be integrated with the memory ED30 of the electronic apparatus ED01, or may include an additional memory that is operated independently.

The ISP 1160 may perform image treatment on the image obtained through the image sensor 1000 or the image data stored in the memory 1150. The image treatments may include a depth map generation, a three-dimensional modeling, a panorama generation, extraction of features, an image combination, and/or an image compensation (e.g., noise reduction, resolution adjustment, brightness adjustment, blurring, sharpening, softening, and the like). The image signal processor 1160 may perform controlling (e.g., exposure time control, read-out timing control, and the like) of the components (e.g., image sensor 1000, and the like) included in the camera module ED80. The image processed by the image signal processor 1160 may be stored again in the memory 1150 for additional process, and/or may be provided to an external component of the camera module ED80 (e.g., the memory ED30, the display device ED60, the electronic apparatus ED02, the electronic apparatus ED04, the server ED08, and the like). The image signal processor 1160 may be integrated with the processor ED20, and/or may be configured as an additional processor that may be independently operated from the processor ED20. When the image signal processor 1160 is configured as an additional processor separately from the processor ED20, the image processed by the image signal processor 1160 may undergo an additional image treatment by the processor ED20 and then may be displayed on the display device ED60.

The AF controller 1130 may be integrated with the image signal processor 1160. The image signal processor 1160 may generate the AF signal by processing signals from the AF pixels of the image sensor 1000, and the AF controller 1130 may convert the AF signal into a driving signal of the actuator 1180 and transfer the signal to the actuator 1180.

The electronic apparatus ED01 may further include one or a plurality of camera modules having different properties and/or functions. The camera module may include components similar to those of the camera module ED80 of FIG. 29, and the image sensor included in the camera module may be implemented as a charge coupled device (CCD) sensor and/or a complementary metal oxide semiconductor (CMOS) sensor and may include one or a plurality of sensors selected from the image sensors having different properties, such as, but not limited to, an RGB sensor, a black and white (BW) sensor, an IR sensor, or a UV sensor. In this case, one of the plurality of camera modules ED80 may include a wide-angle camera and another camera module ED80 may include a telephoto camera. Similarly, one of the plurality of camera modules ED80 may include a front camera and another camera module ED80 may include a rear camera.

The image sensor 1000, according to some embodiments, may be applied to various electronic apparatuses. The image sensor 1000, according to some embodiments, may be applied to a mobile phone or a smartphone, a tablet or a smart tablet, a digital camera or a camcorder, a laptop computer, or a television or a smart television. For example, the smartphone or the smart tablet may include a plurality of high-resolution cameras each including a high-resolution image sensor. Depth information of objects in an image may be extracted, out focusing of the image may be adjusted, and/or objects in the image may be automatically identified by using the high-resolution cameras.

In some embodiments, the image sensor 1000 may be applied to a smart refrigerator, a surveillance camera, a robot, a medical camera, and the like. For example, the smart refrigerator may automatically recognize food in the refrigerator by using the image sensor, and may notify the user of an existence of a certain kind of food, kinds of food put into or taken out, and the like, through a smartphone. Additionally, the surveillance camera may provide an ultra-high-resolution image and may allow the user to recognize an object or a person in the image even in dark environment by using high sensitivity. The robot may be deployed to a disaster and/or industrial site that a person may not directly access, to provide the user with high-resolution images. The medical camera may provide high-resolution images for diagnosis or surgery, and may dynamically adjust a field of view.

In optional or additional embodiments, the image sensor 1000 may be applied to a vehicle. The vehicle may include a plurality of vehicle cameras arranged on various locations. Each of the vehicle cameras may include the image sensor, according to an embodiment. The vehicle may provide a driver with various information about inside the vehicle or around the vehicle by using the plurality of vehicle cameras, and may automatically recognize an object or a person in the image to provide information required to the autonomous travel.

While the image sensor and the electronic apparatus including the image sensor have been particularly shown and described with reference to the embodiments thereof, it will be understood by those of ordinary skill in the art that various changes in form and details may be made therein without departing from the scope as defined by the following claims. The embodiments should be considered in descriptive sense only and not for purposes of limitation. Therefore, the scope of the disclosure is defined not by the detailed description of the disclosure but by the appended claims, and all differences within the scope will be construed as being included in the disclosure.

The color separation lens array included in the image sensor described above may separate the incident light by wavelengths and condense the separated light without absorbing or blocking the incident light, and thus, the light utilization efficiency of an image sensor may be improved.

The color separation lens array included in the above-described image sensor may multi-condense light of the corresponding color onto a plurality of continuously arranged pixels representing the same color. In addition, when each of the plurality of pixels includes a plurality of channels, the uniformity of an optical signal for each channel may be improved, and thus, the image quality of the image sensor may be improved.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An image sensor comprising:
a sensor substrate comprising:
a first pixel group comprising a plurality of first pixels that are continuously arranged;
a second pixel group comprising a plurality of second pixels that are continuously arranged; and
a third pixel group comprising a plurality of third pixels that are continuously arranged; and
a color separation lens array configured to:
separate incident light into green light, blue light, and red light, according to wavelengths;
multi-condense the blue light onto the plurality of first pixels,
multi-condense the green light onto the plurality of second pixels, and
multi-condense the red light onto the plurality of third pixels,
wherein the color separation lens array comprises:
a first pixel correspondence region facing the first pixel group and comprising a plurality of first nanoposts;
a second pixel correspondence region facing the second pixel group and comprising a plurality of second nanoposts; and
a third pixel correspondence region facing the third pixel group and comprising a plurality of third nanoposts,
wherein a blue light phase profile viewed in a first cross-section immediately after passing through the first pixel correspondence region comprises a plurality of first maximum points,
wherein a number of points in the plurality of first maximum points is the same as a first number of pixels in the plurality of first pixels, and
wherein first positions of the plurality of first maximum points are not aligned with and deviate from a first center of the plurality of first pixels.

2. The image sensor of claim 1, wherein the first positions of the plurality of first maximum points are spaced apart from positions facing the first center of the plurality of first pixels in a direction toward a center of the first pixel correspondence region.

3. The image sensor of claim 1 or 2, wherein a red light phase profile viewed from a third cross-section immediately after passing through the third pixel correspondence region comprises a plurality of third maximum points,
wherein a number of the plurality of third maximum points is the same as a number of the plurality of third pixels, and
wherein third positions of the plurality of third maximum points are not aligned with and deviate from a third center of the plurality of third pixels.

4. The image sensor of claim 3, wherein the third positions of the plurality of third maximum points of the red light phase profile are spaced apart from positions facing the third center of the plurality of third pixels in a direction toward a center of the third pixel correspondence region.

5. The image sensor of any preceding claim, wherein a green light phase profile viewed from a second cross-section immediately after passing through the second pixel correspondence region comprises a plurality of second maximum points,
wherein a number of the plurality of second maximum points is the same as a number of the plurality of second pixels, and
wherein second positions of the plurality of second maximum points are not aligned with and deviate from a second center of the plurality of second pixels.

6. The image sensor of claim 5, wherein the second positions of the plurality of second maximum points of the green light phase profile are spaced apart from positions facing the second center of the plurality of second pixels in a direction toward a center of the second pixel correspondence region.

7. The image sensor of any preceding claim, wherein the sensor substrate further comprises a fourth pixel group comprising a plurality of fourth pixels that are continuously arranged, and
wherein the first pixel group, the second pixel group, the third pixel group, and the fourth pixel group are arranged in a 2×2 shape in a first direction and a second direction, and optionally wherein: each of the plurality of first pixels, each of the plurality of second pixels, each of the plurality of third pixels, and each of the plurality of fourth pixels comprises four photosensitive cells arranged in the 2×2 shape in the first and second directions; and
each of the four photosensitive cells are configured to independently sense the incident light.

8. The image sensor of claim 7, wherein at least two areas of cross-sections of the four photosensitive cells are different from each other.

9. The image sensor of claim 7 or 8, wherein each of the plurality of first pixels, each of the plurality of second pixels, each of the plurality of third pixels, and each of the plurality of fourth pixels comprises two photosensitive cells arranged in the 2×2 shape in the first and second directions, and
wherein the two photosensitive cells are configured to independently sense the incident light.

10. An image sensor comprising:
a sensor substrate comprising:
a first pixel group comprising a plurality of first pixels that are continuously arranged;
a second pixel group comprising a plurality of second pixels that are continuously arranged;
a third pixel group comprising a plurality of third pixels that are continuously arranged; and
a fourth pixel group comprising a plurality of fourth pixels that are continuously arranged; and
a color separation lens array configured to:
separate incident light into green light, blue light, and red light, according to wavelengths,
multi-condense the green light onto the plurality of first pixels and the plurality of fourth pixels;
multi-condense the blue light onto the plurality of second pixels, and
multi-condense the red light onto the plurality of third pixels,
wherein the color separation lens array comprises:
a first pixel correspondence region facing the first pixel group and comprising a plurality of first nanoposts;
a second pixel correspondence region facing the second pixel group and comprising a plurality of second nanoposts;
a third pixel correspondence region facing the third pixel group and comprising a plurality of third nanoposts; and
a fourth pixel correspondence region facing the fourth pixel group and comprising a plurality of fourth nanoposts,
wherein the plurality of second nanoposts are arranged to have symmetry with respect to a second diagonal line of a second cross-section of the second pixel correspondence region, and
wherein the plurality of third nanoposts are arranged to have symmetry with respect to a third diagonal line of a third cross-section of the third pixel correspondence region.

11. The image sensor of claim 10, wherein the second pixel correspondence region comprises a plurality of sub regions facing the plurality of second pixels,
wherein four second central nanoposts are disposed at a center of each of the plurality of sub regions, and
wherein cross-sectional sizes of the four second central nanoposts are larger than cross-sectional sizes of the plurality of second nanoposts disposed at a periphery of each of the plurality of sub regions, and optionally wherein a center of an arrangement of the four second central nanoposts is spaced apart from a center of each of the plurality of sub regions toward a center of the second pixel correspondence region.

12. The image sensor of claim 10 or 11, wherein the third pixel correspondence region comprises a plurality of sub regions facing the plurality of third pixels,
wherein four third central nanoposts are disposed at a center of each of the plurality of sub regions, and
wherein cross-sectional sizes of the four third central nanoposts are larger than cross-sectional sizes of the plurality of third nanoposts disposed at a periphery of each of the plurality of sub regions, and optionally wherein a center of an arrangement of the four third central nanoposts is spaced apart from a center of each of the plurality of sub regions toward a center of the third pixel correspondence region.

13. The image sensor of any of claims 10 to 12, wherein the first pixel group, the second pixel group, the third pixel group, and the fourth pixel group are arranged in a 2×2 shape in a first direction and a second direction,
wherein each of the plurality of first pixels, each of the plurality of second pixels, each of the plurality of third pixels, and each of the plurality of fourth pixels comprises four photosensitive cells arranged in the 2×2 matrix shape in the first and second directions, and
wherein the four photosensitive cells are configured to independently sense the incident light, and optionally wherein each of the first pixel correspondence region, the second pixel correspondence region, the third pixel correspondence region, and the fourth pixel correspondence region comprises a plurality of basic regions partitioned in a same number as a number of cells of the four photosensitive cells facing each other, and
wherein four nanoposts having at least two types of cross-sectional sizes are disposed in each of the plurality of basic regions.

14. The image sensor of claim 13, wherein at least two areas of cross-sections of the four photosensitive cells are different from each other.

15. An electronic apparatus comprising:
a lens assembly comprising at least one lens and configured to form an optical image of an object;
an image sensor according to any preceding claim configured to convert the optical image formed by the lens assembly into an electrical signal; and
a processor configured to process a signal generated by the image sensor.
